# EUROPEAN PATENT APPLICATION

(11) **EP 4 576 986 A1**
(43) Date of publication of application: **25.06.2025**
(21) Application number: 24197964.0
(22) Date of filing: 02.09.2024
(51) Int. Cl.: H10D 30/01, H01L 23/31, H10D 30/47, H10D 64/00, H10D 62/85, H10D 64/23, H10D 62/17

(54) **SEMICONDUCTOR DEVICE**

(30) Priority: 20.12.2023 KR 20230187539
(71) Applicant: Samsung Electronics Co., Ltd, Suwon-si, Gyeonggi-do 16677 (KR)
(72) Inventor: PARK, Junhyuk, Suwon-si (KR); KIM, Jongseob, Suwon-si (KR); YANG, Seong Seok, Suwon-si (KR); OH, Jaejoon, Suwon-si (KR)
(74) Representative: Marks & Clerk LLP

(57) **Abstract**

A semiconductor device includes a channel layer, a barrier layer positioned above the channel layer and including a material having a different energy band gap from an energy band gap of the channel layer, a gate electrode positioned above the barrier layer, a gate semiconductor layer positioned between the barrier layer and the gate electrode, a first source electrode positioned on a first side of the gate electrode, and a first drain electrode positioned on a second, opposite side of the gate electrode, the first source electrode and the first drain electrode each connected to the channel layer, a lower protection layer covering the barrier layer and the gate electrode, a first field dispersion plate connected to the first source electrode and positioned above the lower protection layer, and a first interlayer insulating layer positioned above the first field dispersion plate and the lower protection layer and including a first element of a first content (at%) in relation to the entire first interlayer insulating layer. The lower protection layer includes the first element of which a second content (at%) in relation to the entire lower protection layer is less than the first content (at%).

## Description

### BACKGROUND OF THE DISCLOSURE

### 1. Field of the Disclosure

The present disclosure relates to a semiconductor device.

### 2. Description of the Related Art

In modern society, semiconductor devices are closely related to daily life. In particular, the importance of electric power semiconductor devices used in various fields such as transportation fields such as electric vehicles, railways, and electric trams, renewable energy systems such as solar power generation and wind power generation, and mobile devices is gradually increasing. The electric power semiconductor device is a semiconductor device used to handle high voltage or high current, and performs functions such as an electric power conversion and a control in large electric power systems or high power electronic devices. Electric power semiconductor devices have an ability and a durability to handle high electric power, thereby handling the large amounts of the current, and withstanding the high voltages. For example, an electric power semiconductor device may handle the voltages of hundreds to thousands of volts and the currents of tens of amperes to thousands of amperes. Electric power semiconductor devices may improve the efficiency of electrical energy usage by minimizing a power loss. Additionally, electric power semiconductor devices may be operated stably even in environments such as high temperature.

These electric power semiconductor devices may be classified according to materials, and examples include SiC electric power semiconductor devices and GaN electric power semiconductor devices. By manufacturing the electric power semiconductor devices using SiC or GaN instead of conventional silicon wafers (Si wafers), drawbacks of silicon, which has unstable characteristics at high temperatures, may be compensated. SiC electric power semiconductor devices are resistant against high temperatures and have low power loss, and may be suitable for electric vehicles, renewable energy systems, etc. GaN electric power semiconductor devices require high costs, but are efficient in terms of a speed and may be suitable for high-speed charging of mobile devices.

### SUMMARY OF THE DISCLOSURE

Aspects of the disclosed embodiments provide a semiconductor device with stable electric characteristics and improved reliability.

According to an example embodiment, a semiconductor device includes a channel layer, a barrier layer positioned above the channel layer and including a material having a different energy band gap from an energy band gap of the channel layer, a gate electrode positioned above the barrier layer, a gate semiconductor layer positioned between the barrier layer and the gate electrode, a first source electrode positioned on a first side of the gate electrode, and a first drain electrode positioned on a second, opposite side of the gate electrode, the first source electrode and the first drain electrode each connected to the channel layer, a lower protection layer covering the barrier layer and the gate electrode, a first field dispersion plate connected to the first source electrode and positioned above the lower protection layer, and a first interlayer insulating layer positioned above the first field dispersion plate and the lower protection layer and including a first element of a first content (at%) in relation to the entire first interlayer insulating layer. The lower protection layer includes the first element of which a second content (at%) in relation to the entire lower protection layer is less than the first content (at%).

According to an example embodiment, a semiconductor device includes a channel layer, a barrier layer positioned above the channel layer and including a material having a different energy band gap from an energy band gap of the channel layer, a gate electrode positioned above the barrier layer, a gate semiconductor layer positioned between the barrier layer and the gate electrode, a first source electrode positioned on a first side of the gate electrode, and a first drain electrode positioned on a second, opposite side of the gate electrode, the first source electrode and the first drain electrode each connected to the channel layer, a lower protection layer covering the barrier layer and the gate electrode, a field dispersion plate connected to the source electrode and positioned above the lower protection layer, and an interlayer insulating layer positioned above the field dispersion plate and the lower protection layer and including nitrogen. The lower protection layer includes a content (at%) of nitrogen in relation to the entire lower protection layer less than the content (at%) of nitrogen of the interlayer insulating layer in relation to the entire interlayer insulating layer.

According to an example embodiment, a semiconductor device includes a substrate, a channel layer including GaN on the substrate, a barrier layer positioned above the channel layer and including AlGaN, a gate electrode positioned above the barrier layer and including a metal material, a gate semiconductor layer positioned between the barrier layer and the gate electrode and including GaN doped with a P-type impurity, a first source electrode positioned on a first side of the gate electrode, and a first drain electrode positioned on a second, opposite side of the gate electrode, the first source electrode and the first drain electrode each connected to the channel layer, a lower protection layer covering the barrier layer and the gate electrode, a first field dispersion plate connected to the first source electrode, integrated with the first source electrode, and positioned above the lower protection layer, and a first interlayer insulating layer positioned above the first field dispersion plate and the lower protection layer and including a first element and a second element different from the first element. The lower protection layer includes the second element, or the second element and the first element, and the content (at%) of the first element of the lower protection layer in relation to the entire lower protection layer is smaller than the content (at%) of the first element of the interlayer insulating layer in relation to the entire interlayer insulating layer.

According to embodiments, the electric characteristics and reliability of the semiconductor device may be improved. At least some of the above and other features of the invention are set out in the claims.

### BRIEF DESCRIPTION OF THE DRAWINGS

FIG. 1 and FIG. 2 are cross-sectional views showing a semiconductor device according to an embodiment.
FIG. 3 is a graph showing a concentration of a first element according to positions of a lower protection layer and an interlayer insulating layer of a semiconductor device according to an embodiment.
FIG. 4 to FIG. 9 are graphs showing a concentration of a first element according to positions of a lower protection layer and an interlayer insulating layer of a semiconductor device according to some embodiments.
FIG. 10 and FIG. 11 are cross-sectional views showing a semiconductor device according to some embodiments.
FIG. 12 and FIG. 13 are graphs showing a concentration of a first element according to positions of a lower protection layer and an interlayer insulating layer of a semiconductor device according to some embodiments.
FIG. 14 and FIG. 15 are cross-sectional views showing a semiconductor device according to some embodiments.
FIG. 16 to FIG. 18 are graphs showing a concentration of a first element according to positions of a lower protection layer and an interlayer insulating layer of a semiconductor device according to some embodiments.
FIG. 19 and FIG. 20 are cross-sectional views showing a semiconductor device according to some embodiments.
FIG. 21 to FIG. 30 are process cross-sectional views shown according to a process order of manufacturing a semiconductor device according to an embodiment.

### DETAILED DESCRIPTION

The present disclosure will be described more fully hereinafter with reference to the accompanying drawings, in which example embodiments of the disclosure are shown. As those skilled in the art would realize, the described embodiments may be modified in various different ways, all without departing from the scope of the present disclosure.

To clearly describe the present disclosure, portions which do not relate to the description are omitted, and like reference numerals designate like elements throughout the specification.

In the drawings, size and thickness of each element are approximately shown for better understanding and ease of description. Therefore, the present disclosure is not limited to the drawings. In the drawings, the thickness of layers, films, panels, regions, etc., are exaggerated for clarity. In the drawings, the thicknesses of some layers and areas are exaggerated for convenience of explanation.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact. Further, in the specification, the word "on" or "above" means positioned on or below the object portion, and does not necessarily mean positioned on the upper side of the object portion based on a gravitational direction.

In addition, unless explicitly described to the contrary, the word "comprise", and variations such as "comprises" or "comprising", will be understood to imply the inclusion of stated elements but not the exclusion of any other elements.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

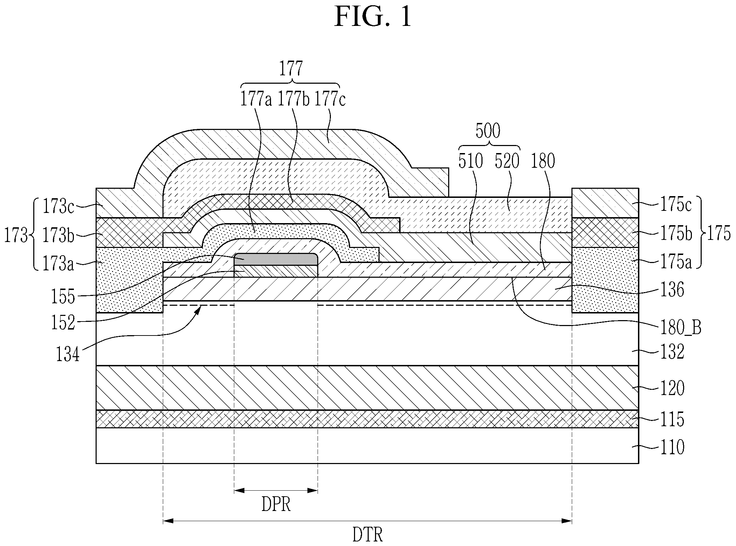

Hereinafter, a semiconductor device according to an embodiment is described with reference to FIG. 1 to FIG. 3.

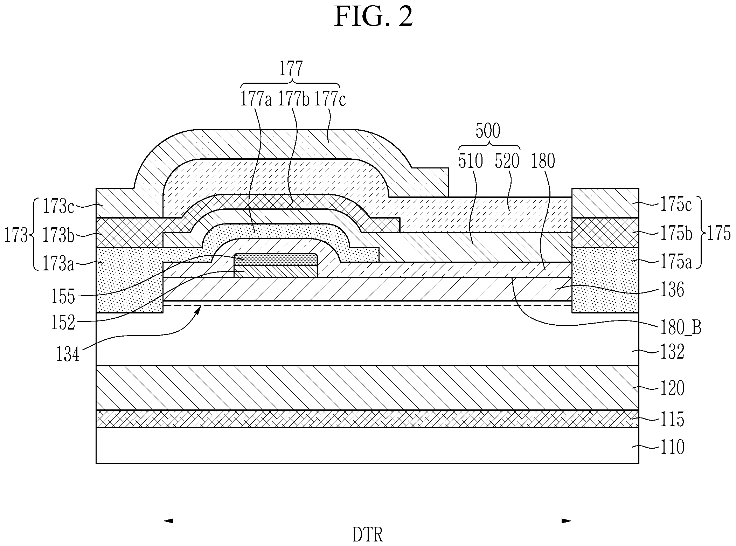

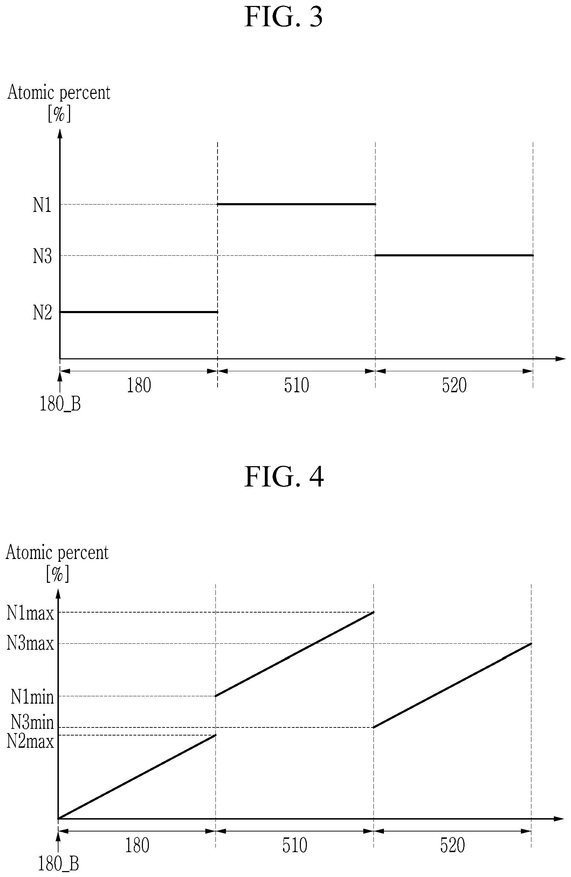

FIG. 1 and FIG. 2 are cross-sectional views showing a semiconductor device according to an embodiment. FIG. 3 is a graph showing a concentration of a first element according to positions of a lower protection layer and an interlayer insulating layer of a semiconductor device according to an embodiment. FIG. 1 represents a case where the semiconductor device according to an embodiment is in an off state. FIG. 2 represents a case where the semiconductor device according to an embodiment is in the on state. The semiconductor device may be a power semiconductor device, such as a switch or other high-power device.

First, as shown in FIG. 1, a semiconductor device according to an embodiment may include a channel layer 132, a barrier layer 136 positioned on the channel layer 132, a gate electrode 155 positioned on the barrier layer 136, a gate semiconductor layer 152 positioned between the barrier layer 136 and the gate electrode 155, a lower protection layer 180 positioned on the barrier layer 136, an interlayer insulating layer 500 positioned on the lower protection layer 180, a source electrode 173 and a drain electrode 175 separated from each other on the channel layer 132, and a field dispersion layer 177 positioned on the lower protection layer 180.

The channel layer 132 is a layer that forms a channel between the source electrode 173 and the drain electrode 175, and a 2-dimensional electron gas (2DEG) 134 may be positioned inside the channel layer 132. The 2-dimensional electron gas 134 is a charge transport model used in solid physics, and refers to a group of electrons that can move freely in a 2-dimensional (e.g., a x-y planar direction) but cannot move in another dimension (e.g., a z direction) and are tightly bound within a 2-dimensional space. For example, the 2-dimensional electron gas 134 may exist in a 2-dimensional paper-like form within a 3-dimensional space. This 2-dimensional electron gas 134 mainly appears in a semiconductor heterojunction structure, and may occur at the interface between the channel layer 132 and the barrier layer 136 in the semiconductor device according to an embodiment. For example, the 2-dimensional electron gas 134 may be generated in the portion closest to the barrier layer 136 within the channel layer 132.

The channel layer 132 may include one or more materials selected from Group III-V materials, such as nitrides including Al, Ga, In, B, or combinations thereof. Throughout the specification, when a component is described as "including" a particular element or group of elements, it is to be understood that the component is formed of only the element or the group of elements, or the element or group of elements may be combined with additional elements to form the component, unless the context clearly and/or explicitly describes the contrary. The term "consisting of," on the other hand, indicates that a component is formed only of the element(s) listed. The channel layer 132 may be composed of a single layer or multiple layers. The channel layer 132 may be AlₓIn_{y}Ga_{(1-x-y)}N (0≤x≤1, 0≤y≤1, x+y≤1). For example, the channel layer 132 may be AIN, GaN, InN, InGaN, AlGaN, AlInN, AlInGaN, or a combination thereof. The channel layer 132 may be a layer with a doped impurity or a layer with an undoped impurity. The thickness of the channel layer 132 may be about several hundred nm or less.

The channel layer 132 may be positioned on the substrate 110, and a seed layer 115 and a buffer layer 120 may be positioned between the substrate 110 and the channel layer 132. The substrate 110, the seed layer 115, and the buffer layer 120 are layers necessary to form the channel layer 132, and may be omitted in some cases. For example, when a substrate made of GaN is used as the channel layer 132, at least one of the substrate 110, the seed layer 115, and the buffer layer 120 may be omitted. Considering that the price of a substrate made of GaN is relatively high, the channel layer 132 including GaN may be grown using the substrate 110 made of Si. As a lattice structure of Si and a lattice structure of GaN are different, it may not be easy to grow the channel layer 132 directly on the substrate 110. Accordingly, after growing the seed layer 115 and the buffer layer 120 on the substrate 110 first, the channel layer 132 may be grown on the buffer layer 120. Additionally, at least one of the substrate 110, the seed layer 115, and the buffer layer 120 may be removed from the final structure of the semiconductor device after being used in the manufacturing process.

The substrate 110 may include a semiconductor material. For example, the substrate 110 may include sapphire, Si, SiC, AIN, GaN, or a combination thereof. The substrate 110 may be a silicon on insulator (SOI) substrate. However, the material of the substrate 110 is not limited to this, and any generally-used substrate may be applied. In some cases, the substrate 110 may include an insulating material. For example, after forming first several layers, including the channel layer 132, on the semiconductor substrate, then the semiconductor substrate may be removed to be replaced with an insulation substrate.

The buffer layer 120 may be positioned on the substrate 110. The seed layer 115 may be further positioned between the substrate 110 and the buffer layer 120. The seed layer 115 may be positioned directly on the substrate 110, for example, to contact a top surface of the substrate. However, it is not limited to this, and another predetermined layer may be further positioned between the substrate 110 and the seed layer 115. The seed layer 115 is a layer that serves as a seed for growing the buffer layer 120, and may be made of a crystal lattice structure that becomes the seed of the buffer layer 120. The buffer layer 120 may be positioned directly on the seed layer 115. However, it is not limited to this, and another predetermined layer may be positioned between the seed layer 115 and the buffer layer 120. As an embodiment, the seed layer 115 may include AlN.

The buffer layer 120 may be positioned between the substrate 110 and the channel layer 132. The buffer layer 120 is a layer to alleviate differences in lattice constants and thermal expansion coefficients between the substrate 110 and the channel layer 132. The buffer layer 120 may include one or more materials selected from Group III-V materials, such as nitrides including Al, Ga, In, B, or combinations thereof. The buffer layer 120 may be AlₓIn_{y}Ga_{(1-x-y)}N (0≤x≤1, 0≤y≤1, x+y≤1). ). For example, the buffer layer 120 may include AIN, GaN, InN, InGaN, AlGaN, AlInN, AlInGaN, or combination thereof. The buffer layer 120 may be composed of a single layer or multiple layers.

The buffer layer 120 of the semiconductor device according to an embodiment may further include a superlattice layer and/or a high-resistance layer. The superlattice layer and the high-resistance layer may be positioned sequentially on the seed layer 115.

The superlattice layer may be positioned above the seed layer 115. The superlattice layer may be positioned directly on the seed layer 115. However, it is not limited to this, and another predetermined layer may be positioned between the seed layer 115 and the superlattice layer. The superlattice layer is a layer to alleviate the difference in lattice constants and thermal expansion coefficients between the substrate 110 and the channel layer 132. The superlattice layer may include one or more materials selected from Group III-V materials, such as nitrides including Al, Ga, In, B, or combinations thereof. The superlattice layer may be AlₓIn_{y}Ga_{(1-x-y)}N (0≤x≤1, 0≤y≤1, x+y≤1). For example, the superlattice layer may include AIN, GaN, InN, InGaN, AlGaN, AlInN, AlInGaN, or combinations thereof. The superlattice layer may be composed of a single layer or multiple layers. For example, the superlattice layer may have a structure in which a layer made of AlGaN and a layer made of GaN are repeatedly stacked. For example, AlGaN/GaN/AlGaN/GaN/AlGaN/GaN may be sequentially stacked to form a superlattice layer. The number of AlGaN layers and GaN that make up the superlattice layer can be changed in various ways, and the material that makes up the superlattice layer may be changed in various ways.

The high-resistance layer may be positioned above the superlattice layer. The high-resistance layer may be positioned directly on the superlattice layer. However, it is not limited to this, and another predetermined layer may be positioned between the superlattice layer and the high-resistance layer. The high-resistance layer may be positioned between the superlattice layer and the channel layer 132. The high-resistance layer may be a layer to prevent the semiconductor device according to an embodiment, including the channel layer 132, from being influenced by the outside. The high-resistance layer may be made of a material with low conductivity so that the substrate 110 and the channel layer 132 are electrically insulated. The high-resistance layer may include one or more materials selected from Group III-V materials, such as nitrides including Al, Ga, In, B, or combinations thereof. The high-resistance layer may be AlₓIn_{y}Ga_{1-x-y}N (0≤x≤1, 0≤y≤1, x+y≤1). For example, the high-resistance layer may include AIN, GaN, InN, InGaN, AlGaN, AlInN, AlInGaN, or combinations thereof. The high-resistance layer may be made of a single layer or multiple layers. The high-resistance layer may be a layer in which an impurity is not doped.

The barrier layer 136 may be positioned above the channel layer 132. The barrier layer 136 may be positioned directly on the channel layer 132. However, it is not limited to this, and another predetermined layer may be positioned between the channel layer 132 and the barrier layer 136. The region of the channel layer 132 that overlaps the barrier layer 136 may become a drift region DTR. The drift region DTR may be positioned between the source electrode 173 and the drain electrode 175. The drift region DTR may mean a region to which carriers move when a potential difference occurs between the source electrode 173 and the drain electrode 175..

The semiconductor device according to an embodiment may be turned on/off depending on whether a voltage is applied to the gate electrode 155 and/or the size of the voltage applied to the gate electrode 155, and accordingly, a movement of carriers in the drift region DTR may be achieved or blocked.

The barrier layer 136 may include one or more materials selected from Group III-V materials, such as nitrides including Al, Ga, In, B, or combinations thereof. The barrier layer 136 may be AlₓIn_{y}Ga_{1-x-y}N (0≤x≤1, 0≤y≤1, x+y≤1). The barrier layer 136 may include GaN, InN, AlGaN, AlInN, InGaN, AlN, AlInGaN or combination thereof. The energy band gap of the barrier layer 136 may be adjusted by a composition ratio of Al and/or In.

The barrier layer 136 may include a semiconductor material with characteristics different from those of the channel layer 132. The barrier layer 136 may differ from the channel layer 132 in at least one of a polarization characteristic, an energy band gap, or a lattice constant. For example, the barrier layer 136 may include a material having a different energy band gap from the channel layer 132. At this time, the barrier layer 136 may have a higher energy band gap than the channel layer 132 and may have a higher electrical polarization rate than the channel layer 132. This barrier layer 136 may cause a 2-dimensional electron gas 134 in the channel layer 132, which has a relatively low electrical polarization rate. In this respect, the barrier layer 136 may also be called a channel supply layer or a 2-dimensional electron gas supply layer. The 2-dimensional electron gas 134 may be formed within a portion of the channel layer 132 positioned below the interface between the channel layer 132 and the barrier layer 136. The 2-dimensional electron gas 134 may have a very high electron mobility.

The barrier layer 136 may be composed of a single layer or multiple layers. If the barrier layer 136 is made of multiple layers, the energy band gap of the material of each layer constituting the multiple layers may be different. In one embodiment, the multiple layers constituting the barrier layer 136 may be arranged so that the energy band gap increases as it approaches the channel layer 132.

The gate electrode 155 may be positioned on the barrier layer 136. The gate electrode 155 may overlap with some regions of the barrier layer 136. The gate electrode 155 may overlap with a part of the drift region DTR of the channel layer 132. The gate electrode 155 may be positioned between the source electrode 173 and the drain electrode 175. The gate electrode 155 may be separated from the source electrode 173 and the drain electrode 175. For example, the gate electrode 155 may be positioned closer to the source electrode 173 than it is to the drain electrode 175. Therefore, the separation distance between the gate electrode 155 and the source electrode 173 may be smaller than the separation distance between the gate electrode 155 and the drain electrode 175, but it is not limited thereto.

The gate electrode 155 may include a conductive material. For example, the gate electrode 155 may include a metal, a metal alloy, a conductive metal nitride, a metal silicide, a doped semiconductor material, a conductive metal oxide, or a conductive metal oxynitride. For example, the gate electrode 155 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride(NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combination thereof, but it is not thereto. The gate electrode 155 may be made of a single layer or multiple layers.

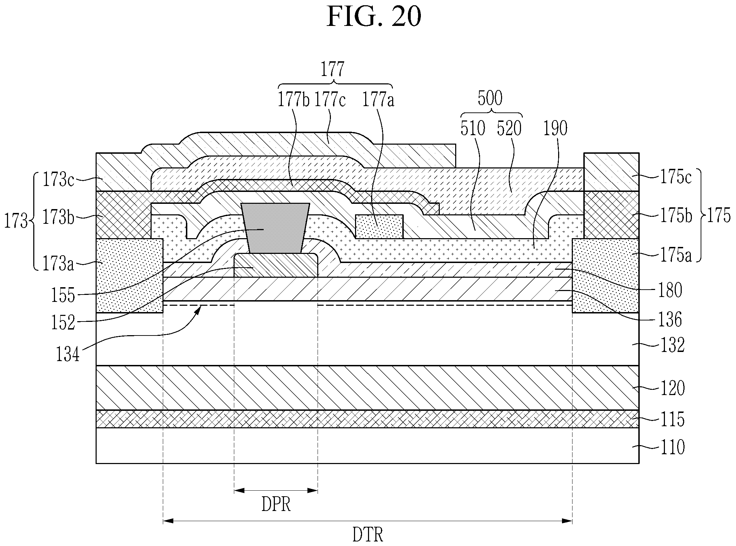

The gate semiconductor layer 152 may be positioned between the barrier layer 136 and the gate electrode 155. The gate semiconductor layer 152 may be positioned on the barrier layer 136, and the gate electrode 155 may be positioned on the gate semiconductor layer 152. The gate electrode 155 may be in Schottky contact or ohmic contact with the gate semiconductor layer 152. The gate semiconductor layer 152 may overlap with the gate electrode 155. At this time, the gate semiconductor layer 152 may completely overlap with the gate electrode 155 in the vertical direction, and the upper surface of the gate semiconductor layer 152 may be entirely covered by the gate electrode 155. For example, the gate semiconductor layer 152 may have substantially the same planar shape as the gate electrode 155, and may fully vertically overlap the gate electrode 155. However, it is not limited thereto, the gate electrode 155 may be positioned to cover at least a part of the gate semiconductor layer 152, but not the entire gate semiconductor layer 152. This is described later with reference to FIG. 20.

The gate semiconductor layer 152 may be positioned between the source electrode 173 and the drain electrode 175. The gate semiconductor layer 152 may be separated from the source electrode 173 and the drain electrode 175. For example, the gate semiconductor layer 152 may be positioned between the first source electrode 173a and the first drain electrode 175a and spaced apart from the first source electrode 173a and the first drain electrode 175a. The gate semiconductor layer 152 may be positioned closer to the source electrode 173 than it is to the drain electrode 175. Therefore, the separation distance between the gate semiconductor layer 152 and the source electrode 173 may be smaller than the separation distance between the gate semiconductor layer 152 and the drain electrode 175, but example embodiments are not limited thereto.

In an embodiment, the gate semiconductor layer 152 may overlap with the gate electrode 155 in a vertical direction (e.g., the thickness direction of the channel layer 132). For example, the gate semiconductor layer 152 may completely overlap with the gate electrode 155 in the vertical direction (e.g., the thickness direction of the channel layer 132). For example, the sides of the gate semiconductor layer 152 may be aligned with the sides of the gate electrode 155. However, the embodiments are not limited thereto, the gate semiconductor layer 152 may partially overlap with the gate electrode 155. This is described later with reference to FIG. 20.

The gate semiconductor layer 152 may include one or more materials selected from Group III-V materials, such as nitrides including Al, Ga, In, B, or combinations thereof. The gate semiconductor layer 152 may be AlₓIn_{y}Ga_{1-x-y}N (0≤x≤1, 0≤y≤1, x+y≤1). For example, the gate semiconductor layer 152 may include AlN, GaN, InN, InGaN, AlGaN, AlInN, AlInGaN, or a combination thereof. The gate semiconductor layer 152 may include a material having a different energy band gap from the barrier layer 136. For example, the gate semiconductor layer 152 may include GaN, and the barrier layer 136 may include AlGaN. The gate semiconductor layer 152 may be doped with a predetermined impurity. The impurity doped in the gate semiconductor layer 152 may be a P-type dopant that can provide a hole. For example, the gate semiconductor layer 152 may include GaN doped with a P-type impurity. For example, the gate semiconductor layer 152 may be made of a p-GaN layer. However, the embodiments are not limited to this, and the gate semiconductor layer 152 may be a p-AlGaN layer. The impurity doped in the gate semiconductor layer 152 may be magnesium (Mg). When the doped impurity (e.g., magnesium) within the gate semiconductor layer 152 is combined with an adjacent predetermined element, the hole concentration within the gate semiconductor layer 152 may be reduced, and the characteristics of the semiconductor device may be degraded accordingly. The gate semiconductor layer 152 may be made of a single layer or multiple layers.

A depletion region DPR may be formed within the channel layer 132 by the gate semiconductor layer 152. The depletion region DPR may be positioned within the drift region DTR and may have a narrower width than the drift region DTR. As the gate semiconductor layer 152, which has the different energy band gap from that of the barrier layer 136, is positioned on the barrier layer 136, the level of the energy band of the portion of the barrier layer 136 that overlaps the gate semiconductor layer 152 may increase. Accordingly, the depletion region DPR may be formed in the region of the channel layer 132 that overlaps the gate semiconductor layer 152. The depletion region DPR may be a region in the channel path of the channel layer 132 in which the 2-dimensional electron gas 134 is not formed or has a lower electron concentration than the remaining regions. The depletion region DPR may refer to a region where the flow of the 2-dimensional electron gas 134 is disconnected within the drift region DTR. As the depletion region DPR occurs, a current does not flow between the source electrode 173 and the drain electrode 175, and the channel path may be blocked. Accordingly, the semiconductor device according to an embodiment, as depicted in Figure 1, may have a normally off characteristic. In other words, Figure 1 depicts the semiconductor device in an off state.

For example, the semiconductor device according to an embodiment may be a normally off high electron mobility transistor (HEMT). As shown in FIG. 1, in a normal state in which no voltage is applied to the gate electrode 155, the depletion region DPR exists, and the semiconductor device according to an embodiment may be in an off state. As shown in FIG. 2, when a voltage higher than a threshold voltage is applied to the gate electrode 155, the depletion region DPR disappears, and the 2-dimensional electron gas 134 within the drift region DTR is not disconnected and may be connected. The 2-dimensional electron gas 134 may be formed throughout the channel path between the source electrode 173 and the drain electrode 175, and the semiconductor device according to an embodiment may be in an on state. In summary, the semiconductor device according to an embodiment may include the semiconductor layers with different electrical polarization characteristics, the semiconductor layer with the relatively high polarization rate may induce the 2-dimensional electron gas 134 in another semiconductor layer heterogeneously jointed thereto. This 2-dimensional electron gas 134 may be used as a channel between the source electrode 173 and the drain electrode 175, and the connection or disconnection of the flow of this 2-dimensional electron gas 134 may be controlled by the bias voltage applied to the gate electrode 155. In the gate off state, the flow of the 2-dimensional electron gas 134 is blocked, so a current may not flow between the source electrode 173 and the drain electrode 175. As the flow of the 2-dimensional electron gas 134 continues in the gate on state, a current may flow between the source electrode 173 and the drain electrode 175.

The seed layer 115, the buffer layer 120, the channel layer 132, the barrier layer 136, and the gate semiconductor layer 152 previously described may be sequentially stacked on the substrate 110. In the semiconductor device according to an embodiment, at least one of the seed layer 115, the buffer layer 120, the channel layer 132, the barrier layer 136, and the gate semiconductor layer 152 may be omitted. These seed layer 115, buffer layer 120, channel layer 132, barrier layer 136, and gate semiconductor layer 152 may be made of the semiconductor material of the same type (e.g., may be formed of the same base semiconductor material), and considering the role of each layer and the performance required for the semiconductor device, the material composition ratio of each layer may be different.

The lower protection layer 180 may be positioned above the barrier layer 136 and the gate electrode 155. The lower protection layer 180 may cover the upper and side surfaces of the gate electrode 155 and the side surfaces of the gate semiconductor layer 152. The lower surface of the lower protection layer 180 is in contact with the barrier layer 136 and the gate electrode 155. Accordingly, the barrier layer 136, the gate semiconductor layer 152, and the gate electrode 155 may be protected by the lower protection layer 180. However, the embodiments are not limited thereto, and the gate electrode 155 may penetrate the lower protection layer 180 to be connected to the gate semiconductor layer 152, and the lower protection layer 180 may not cover the upper surface of the gate electrode 155. Also, the lower surface of the lower protection layer 180 may be in contact with the gate semiconductor layer 152. These examples are described with reference to FIG. 20 later.

In an embodiment, the lower protection layer 180 may be positioned between a source electrode 173 and a drain electrode 175, which will be described later. For example, the lower protection layer 180 may be positioned between a first source electrode 173a and a first drain electrode 175a, which will be described later. The side of the lower protection layer 180 may be in contact with the source electrode 173 and the drain electrode 175. For example, the lower protection layer 180 may be in contact with the side of the first source electrode 173a and the side of the first drain electrode 175a.

The lower protection layer 180 may be positioned between the barrier layer 136 and a field dispersion layer 177, which will be explained later. For example, the lower protection layer may fill a part between the barrier layer 136 and a first field dispersion layer 177a, which will be explained later. At least a portion of the lower protection layer 180 may overlap with the field dispersion layer 177 in the vertical direction (e.g., the thickness direction of the channel layer 132). Accordingly, the portion of the lower protection layer 180 that overlaps the field dispersion layer 177 in the vertical direction (for example, the thickness direction of the channel layer 132) may cover the gate semiconductor layer 152 and the gate electrode 155.

In an embodiment, the lower protection layer 180 may include an insulating material. For example, the lower protection layer 180 may include silicon oxide (SiO₂), silicon carbon oxide (SiOC), or a combination thereof. Also, the lower protection layer 180 may include silicon oxynitride (SiON), silicon carbon nitride (SiCN), silicon oxycarbonitride (SiOCN), silicon nitride (SiN), or a combination thereof. For another example, the lower protection layer 180 may include a material such as aluminum oxide (Al₂O₃), etc.

In an embodiment, the lower protection layer 180 may include a first element and a second element different from the first element. In the examples described in the present disclosure, the first element may be nitrogen (N), and the second element may be silicon (Si). For example, if the lower protection layer 180 includes silicon oxynitride (SiON), silicon carbon nitride (SiCN), silicon oxycarbonitride (SiOCN), silicon nitride (SiN), or a combination thereof, the first element may be nitrogen (N), and the second element may be silicon (Si).

The lower protection layer 180 may include the first element of a second content (at%). Here, the first element of the second content (at%) of the lower protection layer 180 may mean the content (at%) of the first element for the entire content of the lower protection layer 180. For example, if the lower protection layer 180 includes silicon oxynitride (SiON), the content (at%) of nitrogen(N) may refer to the content of nitrogen as compared to the entire content of silicon (Si), nitrogen (N), and oxygen (O) of the entire lower protection layer 180, and may be described as a content (at%) in relation to the entire lower protection layer 180. As another example, if the lower protection layer 180 includes silicon nitride (SiN), the content (at%) of nitrogen (N) may refer to the content of nitrogen as compared to the entire content of silicon (Si) and nitrogen (N) in the entire lower protection layer 180. For example, the second content (at%) of the first element of the lower protection layer 180 may be about 0 at% or more and less than about 1at% (e.g., greater than 0% and less than or equal to 1%). For example, when the lower protection layer 180 includes silicon oxynitride (SiON), the second content (at%) of nitrogen (N) in the lower protection layer 180 may be about 0 at% or more and less than about 1 at% (e.g., greater than 0% and less than or equal to 1%). On the other hand, when the lower protection layer 180 includes silicon oxide (SiO₂), the second content (at%) of nitrogen (N) of the lower protection layer 180 may be 0 at%. As described herein, a content refers to an amount of a particular element or material in a structure. For example, the content may refer to an amount of an element in a layer. The amount may refer to an absolute amount, or a relative amount (e.g., ratio or percent). One example of a relative amount (e.g., relative content) as described herein is at% (atomic percent), though a relative content could refer to an atomic ratio, a weight percent, or other relative values. In addition, the content within vertical sections of a layer may change, as discussed in connection with various figures, based on a distance from a bottom surface of the lower protection layer 180. In these cases, the content at a particular vertical section or height may be described as a content at a particular height, as a content at a particular vertical level, or as a content for a vertical-level slice. Accordingly, an overall content for the entire layer may be described as a content throughout a thickness of the entire layer, whereas a content for a vertical-level slice within a particular layer may be referred to as a sub-content or a vertical-level slice content.

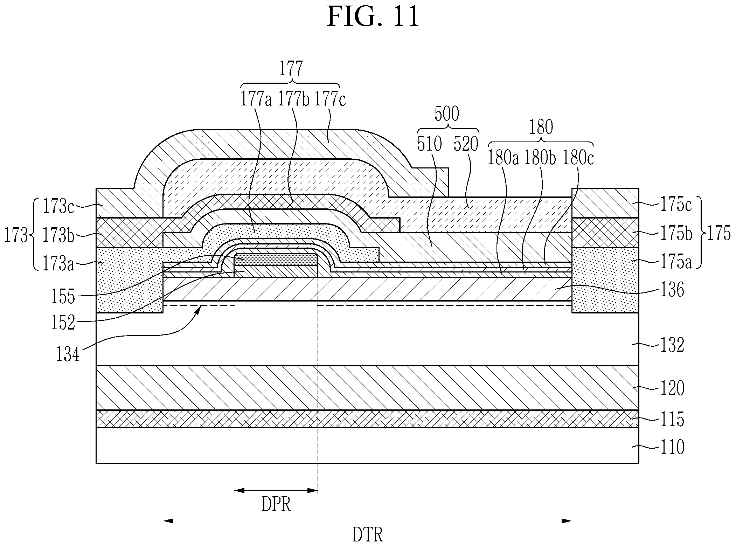

In an embodiment, the lower protection layer 180 was described as being formed of a single layer, but the embodiments are not limited thereto. For example, the lower protection layer 180 may be comprised of multiple layers sequentially stacked on the barrier layer 136. This is described with reference to FIG. 11 to FIG. 13 later.

As the lower protection layer 180 of the semiconductor device according to an embodiment includes the first element of the second content (at%), it is possible to prevent moisture or oxygen from penetrating into the channel layer 132, and a dangling bond state of the insulating material positioned at the interface of the barrier layer 136 may be removed.

An interlayer insulating layer 500 may be positioned on the lower protection layer 180. The interlayer insulating layer 500 may cover the lower protection layer 180. For example, the interlayer insulating layer 500 may be positioned on the lower protection layer 180 between the source electrode 173 and the drain electrode 175. The interlayer insulating layer 500 may overlap the drift region DTR of the channel layer 132 in the vertical direction (for example, the thickness direction of the channel layer 132). The interlayer insulating layer 500 may be not contact the gate electrode 155 or the gate semiconductor layer 152, but the embodiments are not limited thereto. The bottom surface of the interlayer insulating layer 500 may be in contact with the lower protection layer 180 and the first field dispersion layer 177a. The side of the interlayer insulating layer 500 may be in contact with the source electrode 173 and the drain electrode 175. However, the embodiments not limited thereto. In some embodiments, the interlayer insulating layer 500 may cover at least part of upper surfaces of the source electrode 173 and the drain electrode 175.

The interlayer insulating layer 500 of the semiconductor device according to an embodiment may include a first interlayer insulating layer 510 and a second interlayer insulating layer 520.

The first interlayer insulating layer 510 may be positioned above the lower protection layer 180 and a first field dispersion layer 177a, which will be explained later. The first interlayer insulating layer 510 may cover the lower protection layer 180 and a first field dispersion layer 177a, which will be explained later. The first interlayer insulating layer 510 may be positioned between the first field dispersion layer 177a and the second field dispersion layer 177b. For example, the first interlayer insulating layer 510 may be positioned on the lower protection layer 180 between the second source electrode 173b and the second drain electrode 175b. The first interlayer insulating layer 510 may overlap the drift region DTR of the channel layer 132 in the vertical direction (for example, the thickness direction of the channel layer 132). The first interlayer insulating layer 510 may not contact the gate electrode 155 and the gate semiconductor layer 152, but the embodiments are not limited thereto. The bottom surface of the first interlayer insulating layer 510 may be in contact with the lower protection layer 180 and the first field dispersion layer 177a. The side of the first interlayer insulating layer 510 may be in contact with the second source electrode 173b and the second drain electrode 175b. However, the embodiments are not limited thereto. In some embodiments, the first interlayer insulating layer 510 may cover at least part of the upper surface of the first source electrode 173a and the first drain electrode 175a.

In an embodiment, the first interlayer insulating layer 510 may include an insulating material. For example, the first interlayer insulating layer 510 may include silicon oxynitride (SiON), silicon carbon nitride (SiCN), silicon oxycarbonitride (SiOCN), silicon nitride (SiN), or a combination thereof. Also, the first interlayer insulating layer 510 may include a material such as aluminum oxide (Al₂O₃).

In an embodiment, the first interlayer insulating layer 510 may include a first element and a second element different from the first element. For example, the first element may be nitrogen (N), and the second element may be silicon (Si). For example, if the first interlayer insulating layer 510 includes silicon oxynitride (SiON), silicon carbon nitride (SiCN), silicon oxycarbonitride (SiOCN), silicon nitride (SiN), or a combination thereof, the first element may be nitrogen (N), and the second element may be silicon (Si).

The first interlayer insulating layer 510 may include the first element of a first content (at%). Here, the first element of the first content (at%) of the first interlayer insulating layer 510 may mean the content (at%) of the first element for the entire content of the first interlayer insulating layer 510. For example, if the first interlayer insulating layer 510 includes silicon oxynitride (SiON), the content (at%) of nitrogen(N) may refer to the content of nitrogen as compared to the entire content of silicon (Si), nitrogen (N), and oxygen (O) of the first interlayer insulating layer 510, and may be described as a content (at%) in relation to the entire first interlayer insulating layer 510. For example, the first content (at%) of the first element of the first interlayer insulating layer 510 may be greater than about 0at% and less than about 60at%, preferably in some embodiments about 3at% to about 30at%.

Further referring to FIG. 3, in an embodiment, the first content (at%) of the first element of the first interlayer insulating layer 510 may be greater than the second content (at%) of the first element of the lower protection layer 180. For example, the first content (at%) of the first element of the first interlayer insulating layer 510 and the second content (at%) of the first element of the lower protection layer 180 may have constant values without a relationship to the distance from the bottom surface 180_B of the lower protection layer 180. For example, the first content N1(at%) of the first element of the first interlayer insulating layer 510 may be larger than the second content N2(at%) of the first element of the lower protection layer 180. However, the embodiments are not limited thereto. In some embodiments, the first content (at%) of the first element of the first interlayer insulating layer 510 and/or the second content (at%) of the first element of the lower protection layer 180 may have different values depending on the distance from the bottom surface 180_B of the lower protection layer 180. This is described with reference to FIG. 4 to FIG. 9 later.

As an example, when the first interlayer insulating layer 510 and the lower protection layer 180 include the same material such as silicon oxynitride (SiON), the first content (at%) of nitrogen (N) in the first interlayer insulating layer 510 may be greater than the second content (at%) of nitrogen (N) in the lower protection layer 180. Therefore, the sum of the content (at%) of silicon (Si) and the content of oxygen (O) for the entire content (at%) of the first interlayer insulating layer 510 may be smaller than the sum of the content (at%) of silicon (Si) and the content of oxygen (O) for the entire content (at%) of the lower protection layer 180. As another example, if the first interlayer insulating layer 510 includes silicon oxynitride (SiON) and the lower protection layer 180 includes silicon oxide SiO₂, the first content (at%) of nitrogen (N) in the first interlayer insulating layer 510 may be greater than the second content (at%) of nitrogen (N) in the lower protection layer 180. In this case, the lower protection layer 180 may not include the first element (e.g., nitrogen(N)). That is, the second content (at%) of the first element of the lower protection layer 180 may be 0.

As another example, when the first interlayer insulating layer 510 and the lower protection layer 180 include silicon nitride (SiN), the first content (at%) of nitrogen (N) in the first interlayer insulating layer 510 may be greater than the second content (at%) of nitrogen (N) in the lower protection layer 180. Therefore, the content (at%) of silicon (Si) for the entire content (at%) of the first interlayer insulating layer 510 may be less than the content (at%) of silicon (Si) for the entire content (at%) of the lower protection layer 180.

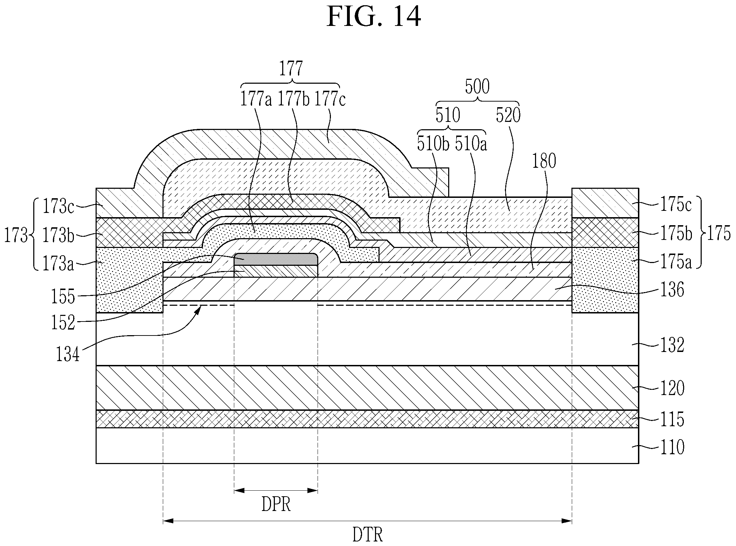

In an embodiment, the first interlayer insulating layer 510 was described as being composed of a single layer, but it is not limited thereto. For example, the first interlayer insulating layer 510 may be composed of multiple layers sequentially stacked on the lower protection layer 180. This is described with reference to FIG. 14 to FIG. 18.

As the first interlayer insulating layer 510 of the semiconductor device according to an embodiment includes the first element of the first content (at%), the semiconductor device may have stable electric characteristics and the reliability may be improved.

The second interlayer insulating layer 520 may be positioned above the first interlayer insulating layer 510 and a second field dispersion layer 177b, which will be explained later. The second interlayer insulating layer 520 may cover the first interlayer insulating layer 510 and a second field dispersion layer 177b, which will be explained later. For example, the second interlayer insulating layer 520 may be positioned on the first interlayer insulating layer 510 between the third source electrode 173c and the third drain electrode 175c. The second interlayer insulating layer 520 may overlap the drift region DTR of the channel layer 132 in the vertical direction (for example, the thickness direction of the channel layer 132). The second interlayer insulating layer 520 may be not in contact with the gate electrode 155 or the gate semiconductor layer 152, but the embodiments are not limited thereto. The bottom surface of the second interlayer insulating layer 520 may be in contact with the first interlayer insulating layer 510 and the second field dispersion layer 177b. The side of the second interlayer insulating layer 520 may be in contact with the third source electrode 173c and the third drain electrode 175c. However, the embodiments not limited thereto. In some embodiments, the second interlayer insulating layer 520 may cover at least part of the upper surface of the third source electrode 173c and the third drain electrode 175c.

In an embodiment, the second interlayer insulating layer 520 may include an insulating material. The second interlayer insulating layer 520 may include or consist of the same material as the first interlayer insulating layer 510, but the embodiments not limited thereto. For example, the second interlayer insulating layer 520 may include silicon oxynitride (SiON), silicon carbon nitride (SiCN), silicon oxycarbonitride (SiOCN), silicon nitride (SiN), or a combination thereof. Also, the second interlayer insulating layer 520 may include a material such as aluminum oxide (Al₂O₃).

In an embodiment, the second interlayer insulating layer 520 may include a first element and a second element different from the first element. Here, the first element may be nitrogen (N), and the second element may be silicon (Si). As an example, if the second interlayer insulating layer 520 includes silicon oxynitride (SiON), silicon carbon nitride (SiCN), silicon oxycarbonitride (SiOCN), silicon nitride (SiN), or a combination thereof, the first element may be nitrogen (N). and the second element may be silicon (Si).

The second interlayer insulating layer 520 may include the first element of a third content (at%). Here, the third content (at%) of the first element of the second interlayer insulating layer 520 may mean the content (at%) of the first element for the entire content of the second interlayer insulating layer 520. For example, when the second interlayer insulating layer 520 includes silicon oxynitride (SiON), the content (at%) of nitrogen (N) may refer to the content of nitrogen as compared to the entire content of silicon (Si), nitrogen (N), and oxygen (O) of the entire second interlayer insulating layer 520, and may be described as a content (at%) in relation to the entire second interlayer insulating layer 520.

Referring further to FIG. 3, in an embodiment, the third content (at%) of the first element of the second interlayer insulating layer 520 may be greater than the second content (at%) of the first element of the lower protection layer 180. For example, the third content (at%) of the first element of the second interlayer insulating layer 520 and the second content (at%) of the first element of the lower protection layer 180 may be constant values throughout the vertical thickness of each layer, without changing based on the distance from the bottom surface 180_B of the lower protection layer 180, and the third content N3 (at%) of the first element of the second interlayer insulating layer 520 may be larger than the second content N2 (at%) of the first element of the lower protection layer 180. However, the embodiments are not limited thereto. In some embodiments, the third content N3(at%) of the first element of the second interlayer insulating layer 520 may include a part that is equal to or smaller than the first content N1(at%) of the first element of the lower protection layer 180. In this example, one or both of the third content N3(at%) and first content N1(at%) may not be constant throughout the vertical thickness of the respective layer.

Additionally, the third content (at%) of the first element of the second interlayer insulating layer 520 may be smaller than the first content (at%) of the first element of the first interlayer insulating layer 510. For example, the third content (at%) of the first element of the second interlayer insulating layer 520 and the first content (at%) of the first element of the first interlayer insulating layer 510 may have constant value without the relationship to the distance from the bottom surface 180_B of the lower protection layer 180 (e.g., throughout the vertical thickness of each layer), and the third content N3(at%) of the first element of the second interlayer insulating layer 520 may be smaller than the first content N1(at%) of the first element of the first interlayer insulating layer 510. However, the embodiments are not limited thereto. In some embodiments, the third content (at%) of the first element of the second interlayer insulating layer 520, the first content (at%) of the first element of the first interlayer insulating layer 510, and/or the second content (at%) of the first element of the lower protection layer 180 may have different values depending on the distance from the bottom surface of the lower protection layer 180.

In an example embodiment, when the second interlayer insulating layer 520, the first interlayer insulating layer 510, and the lower protection layer 180 include silicon oxynitride (SiON), the third content (at%) of nitrogen (N) of the second interlayer insulating layer 520 may be greater than the second content (at%) of nitrogen (N) of the lower protection layer 180. Additionally, the third content (at%) of nitrogen (N) of the second interlayer insulating layer 520 may be smaller than the first content (at%) of nitrogen (N) of the first interlayer insulating layer 510. Therefore, the sum of the content (at%) of silicon (Si) and the content of oxygen (O) for the entire content (at%) of the second interlayer insulating layer 520 may be smaller than the sum of the content (at%) of silicon (Si) and the content of oxygen (O) for the entire content (at%) of the lower protection layer 180. In addition, the sum of the content (at%) of silicon (Si) and the content of oxygen (O) for the entire content (at%) of the second interlayer insulating layer 520 may be greater than the sum of the content (at%) of silicon (Si) and the content of oxygen (O) for the entire content (at%) of the first interlayer insulating layer 510. As another example, when the second interlayer insulating layer 520 includes silicon oxynitride (SiON) and the lower protection layer 180 includes silicon oxide (SiO₂), the third content (at%) of nitrogen (N) of the second interlayer insulating layer 520 may be greater than or equal to the second content (at%) of nitrogen (N) of the lower protection layer 180. In this case, the lower protection layer 180 may not include the first element (e.g., nitrogen(N)). That is, the second content (at%) of the first element of lower protection layer 180 may be 0.

As another example, when the second interlayer insulating layer 520, the first interlayer insulating layer 510, and the lower protection layer 180 include silicon nitride (SiN), the third content (at%) of nitrogen (N) in the second interlayer insulating layer 520 may be greater than the second content (at%) of nitrogen (N) in the lower protection layer 180. Additionally, the third content (at%) of nitrogen (N) of the second interlayer insulating layer 520 may be smaller than the first content (at%) of nitrogen (N) of the first interlayer insulating layer 510. Therefore, the content (at%) of silicon(Si) for the entire content (at%) of the second interlayer insulating layer 520 may be less than or equal to the content (at%) of silicon(Si) for the entire content (at%) of the lower protection layer 180. In addition, the content (at%) of silicon(Si) for the entire content (at%) of the second interlayer insulating layer 520 may be larger than the content (at%) of silicon(Si) for the entire content (at%) of the first interlayer insulating layer 510.

In one embodiment, the second interlayer insulating layer 520 was described as being composed of a single layer, but it is not limited thereto. For example, the second interlayer insulating layer 520 may be comprised of multiple layers sequentially stacked on top of the lower protection layer 180.

As the second interlayer insulating layer 520 of the semiconductor device according to an embodiment includes the first element of the first content (at%), the semiconductor device may have stable electric characteristics and the reliability may be improved.

In addition, the interlayer insulating layer 500 of the semiconductor device according to an embodiment was described as consisting of two layers, but it is not limited thereto. As an example, the interlayer insulating layer 500 may be composed of a single layer. However, even in this case, the content (at%) of the first element of the interlayer insulating layer 500 may be larger than the content of the first element of the lower protection layer 180. As another example, the interlayer insulating layer 500 may be composed of three or more layers. In this case, the content of the first element of the interlayer insulating layer 500 positioned directly above the lower protection layer 180 may be larger than the content of the first element of the interlayer insulating layer 500 positioned separately from the lower protection layer 180. As can be seen in FIG. 1 and other embodiments, the lower protection layer 180 may be formed of a continuous material layer, formed continuously horizontally between where it contacts a side surface of the source electrode 173 and where it contacts a facing side surface of the drain electrode 175. Therefore, between these side surfaces, the lower protection layer 180 may have a continuous structure, to form a monolithic piece or material having no grain boundaries therebetween. The same may apply for the first interlayer insulating layer 510 and the second interlayer insulating layer 520.

The source electrode 173 and the drain electrode 175 may be positioned above the channel layer 132. The source electrode 173 and the drain electrode 175 may contact with the channel layer 132 and may be electrically connected to the channel layer 132. The source electrode 173 and the drain electrode 175 may be spaced apart from each other, and the gate electrode 155 and the gate semiconductor layer 152 may be positioned between the source electrode 173 and the drain electrode 175. The gate electrode 155 and the gate semiconductor layer 152 may be separated from the source electrode 173 and the drain electrode 175. For example, the source electrode 173 may be electrically connected to the channel layer 132 on one side of the gate electrode 155, and the drain electrode 175 may be electrically connected to the channel layer 132 on the other side of the gate electrode 155. The source electrode 173 and the drain electrode 175 may be positioned outside the drift region DTR of the channel layer 132. The interface between the source electrode 173 and the channel layer 132 may be one edge of the drift region DTR. Likewise, the interface between the drain electrode 175 and the channel layer 132 may be the other edge (e.g., an opposite edge) of the drift region DTR.

However, the present disclosure is not limited to this, and the source electrode 173 and the drain electrode 175 may not be positioned outside the drift region DTR of the channel layer 132. For example, in one embodiment, the channel layer 132 may not be recessed where it overlaps the source electrode 173 and the drain electrode 175, and the source electrode 173 and the drain electrode 175 may be positioned on the upper surface of the channel layer 132. The bottom surface of the source electrode 173 and the drain electrode 175 may be in contact with the top surface of the channel layer 132. The portion of the barrier layer 136 in contact with the source electrode 173 and the drain electrode 175 may be doped with high concentration. The carrier passing through the two-dimensional electron gas 134 may pass through the portion of the barrier layer 136 doped at high concentration, for example, the upper part of the barrier layer 136, and be transferred to the source electrode 173 and the drain electrode 175. In some embodiments where a side surface of the channel layer contacts a side surface of the source electrode 173 and a side surface of the drain electrode 175, the source electrode 173 and the drain electrode 175 may contact the two-dimensional electron gas 134 in the horizontal direction. However, in other embodiments, for example if there is no recess formed in the channel layer 132, the source electrode 173 and the drain electrode 175 may not contact the two-dimensional electron gas 134 in the horizontal direction. The horizontal direction refers to a direction parallel to the upper surface of the channel layer 132 or barrier layer 136.

The source electrode 173 and the drain electrode 175 may include a conductive material. For example, the source electrode 173 and the drain electrode 175 may include a metal, a metal alloy, a conductive metal nitride, a metal silicide, a doped semiconductor material, a conductive metal oxide, or a conductive metal oxynitride. For example, the source electrode 173 and the drain electrode 175 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combination thereof, but are not limited thereto. The source electrode 173 and the drain electrode 175 may be made of a single layer or multiple layers. The source electrode 173 and the drain electrode 175 may be in ohmic contact with the channel layer 132. The region in contact with the source electrode 173 and the drain electrode 175 within the channel layer 132 may be doped at a relatively high concentration compared to other regions (the other regions being either at a different vertical level and/or at a different horizontal position than the contact region).

The source electrode 173 may include a first source electrode 173a, a second source electrode 173b, and a third source electrode 173c. The second source electrode 173b may be positioned above the first source electrode 173a. The third source electrode 173c may be positioned above the second source electrode 173b. The first source electrode 173a may be described as a first source electrode layer or sub-layer, the second source electrode 173b may be described as a second source electrode layer or sub-layer, and the third source electrode 173c may be described as a third source electrode layer or sub-layer. The first source electrode 173a may contact the channel layer 132 and be electrically connected to the channel layer 132. The second source electrode 173b and the third source electrode 173c may not contact the channel layer 132, and may be electrically connected to the channel layer 132 through the first source electrode 173a.

Additionally, the drain electrode 175 may include a first drain electrode 175a, a second drain electrode 175b, and a third drain electrode 175c. The second drain electrode 175b may be positioned above the first drain electrode 175a. The third drain electrode 175c may be positioned above the second drain electrode 175b. The first drain electrode 175a may be described as a first drain electrode layer or sub-layer, the second drain electrode 175b may be described as a second drain electrode layer or sub-layer, and the third drain electrode 175c may be described as a third drain electrode layer or sub-layer. The first drain electrode 175a may contact the channel layer 132 and can be electrically connected to the channel layer 132. The second drain electrode 175b and the third drain electrode 175c may not contact the channel layer 132, and may be electrically connected to the channel layer 132 through the first drain electrode 175a.

The first source electrode 173a and the first drain electrode 175a may be positioned above the channel layer 132. The first source electrode 173a and the first drain electrode 175a may be formed of the same material(s) as each other, and may be formed at the same vertical level as each other (e.g., to have bottom surfaces at the same vertical level above a top surface of the substrate 110 and top surfaces at the same vertical level above a top surface of the substrate 110. The first source electrode 173a and the first drain electrode 175a may contact the channel layer 132. Specifically, a trench that penetrates the lower protection layer 180 and the barrier layer 136 and recesses the upper surface of the channel layer 132 may be positioned on opposite sides of the gate electrode 155 to be spaced apart from each other. The first source electrode 173a and the first drain electrode 175a may be positioned in the trenches positioned on opposite sides of the gate electrode 155, respectively. The first source electrode 173a and the first drain electrode 175a may be formed to fill the trench. Within the trench, the first source electrode 173a and the first drain electrode 175a may be in contact with the channel layer 132 and the barrier layer 136. The channel layer 132 may form the bottom surface and the sidewall of the trench, and the barrier layer 136 may form the sidewall of the trench. Accordingly, the first source electrode 173a and the first drain electrode 175a may be in contact with the upper and side surfaces of the channel layer 132. Additionally, the first source electrode 173a and the first drain electrode 175a may be in contact with the side of the barrier layer 136. Therefore, the first source electrode 173a and the first drain electrode 175a may cover sides of the channel layer 132 and the barrier layer 136.

In an embodiment, the first source electrode 173a and the first drain electrode 175a may cover (and contact) the sides of the lower protection layer 180. The upper surface of the first source electrode 173a and the first drain electrode 175a may protrude (in a vertical direction) from the upper surface of the lower protection layer 180. However, the embodiments are not limited thereto. In one embodiment, the first source electrode 173a and the first drain electrode 175a may cover at least part of the side of the lower protection layer 180 and may not cover the remaining part of the side of the lower protection layer 180.

The second source electrode 173b may be positioned above the first source electrode 173a. The first source electrode 173a may contact the channel layer 132 and be electrically connected to the channel layer 132. The second source electrode 173b may not contact the channel layer 132, and may be electrically connected to the channel layer 132 through the first source electrode 173a.

The second drain electrode 175b may be positioned above the first drain electrode 175a. The first drain electrode 175a may contact the channel layer 132 and be electrically connected to the channel layer 132. The second drain electrode 175b may not contact the channel layer 132, and may be electrically connected to the channel layer 132 through the first drain electrode 175a.

The second source electrode 173b and the second drain electrode 175b may penetrate a first interlayer insulating layer 510, which will be explained later. Specifically, the opening that penetrates the first interlayer insulating layer 510 may be positioned to overlap the first source electrode 173a, and the second source electrode 173b may be positioned within the opening. The second source electrode 173b may be formed to fill the opening. Within the opening, the second source electrode 173b may be in contact with the first source electrode 173a. The second source electrode 173b may be connected to the first source electrode 173a through the opening. Another opening that penetrates the first interlayer insulating layer 510 may be positioned to overlap the first drain electrode 175a, and the second drain electrode 175b may be positioned within the opening. The second drain electrode 175b may be formed to fill the opening. Within the opening, the second drain electrode 175b may be in contact with the first drain electrode 175a. The second drain electrode 175b may be connected to the first drain electrode 175a through the opening. The upper surface of the second source electrode 173b and the second drain electrode 175b may protrude from the upper surface of the first interlayer insulating layer 510, but the embodiments are not limited thereto.

The opening filled with the second source electrode 173b may overlap with the trench filled with the first source electrode 173a. The opening filled with the second source electrode 173b may completely overlap with the first source electrode 173a. However, the embodiments are not limited to this, and in some cases, at least a part of the opening filled with the second source electrode 173b may not overlap with the first source electrode 173a. Additionally, the opening filled with the second drain electrode 175b may overlap with the trench filled with the first drain electrode 175a. The opening filled with second drain electrode 175b may completely overlap with first drain electrode 175a. However, the embodiments are not limited to this, and in some cases, at least a portion of the opening filled with the second drain electrode 175b may not overlap with the first drain electrode 175a.

The third source electrode 173c may be positioned above the second source electrode 173b. The third source electrode 173c may not contact the channel layer 132, and may be electrically connected to the channel layer 132 through the second source electrode 173b and the first source electrode 173a. Additionally, the third drain electrode 175c may be positioned above the second drain electrode 175b. The third drain electrode 175c may not contact the channel layer 132, and may be electrically connected to the channel layer 132 through the second drain electrode 175b and the first drain electrode 175a.

The third source electrode 173c and the third drain electrode 175c may penetrate a second interlayer insulating layer 520, which will be explained later. Specifically, the opening penetrating the second interlayer insulating layer 520 may be positioned to overlap the second source electrode 173b, and the third source electrode 173c may be positioned within the opening. The third source electrode 173c may be formed to fill the opening. Within the opening, the third source electrode 173c may be in contact with the second source electrode 173b. The third source electrode 173c may be connected to the second source electrode 173b through the opening. Since the remaining descriptions of the third source electrode 173c and the third drain electrode 175c are substantially the same as the descriptions of the second source electrode 173b and the second drain electrode 175b, they will be omitted.

In FIG. 1 and FIG. 2, the semiconductor device according to an embodiment is shown as including three pairs of sub-layers of the source electrode 173 and the drain electrode 175, but the number of sub-layers of the source electrode 173 and the drain electrode 175 is not limited thereto. For example, the semiconductor device according to an embodiment may include two or less pairs of sub-layers of the source electrode 173 and the drain electrode 175. Alternatively, each of the source electrode 173 and the drain electrode 175 may include four or more pairs of sub-layers.

The field dispersion layer 177 may be positioned between the source electrode 173 and the drain electrode 175. The field dispersion layer 177 may cover the gate electrode 155. The field dispersion layer 177 may overlap with the gate electrode 155 in the vertical direction (for example, the thickness direction of the channel layer 132). The field dispersion layer 177 may be electrically connected to the source electrode 173. For example, the field dispersion layer 177 may be connected to the source electrode 173, for example, to extend from the source electrode 173.

The field dispersion layer 177 of the semiconductor device according to an embodiment may include a first field dispersion layer 177a, a second field dispersion layer 177b, and a third field dispersion layer 177c (each may be described as a sub-layer).

The first field dispersion layer 177a may be positioned above the lower protection layer 180. The first field dispersion layer 177a may be positioned between the source electrode 173 and the drain electrode 175. The first field dispersion layer 177a may overlap with the gate electrode 155 in the vertical direction (for example, the thickness direction of the channel layer 132). The gate electrode 155 may be covered by the first field dispersion layer 177a. The first field dispersion layer 177a may be positioned between the lower protection layer 180 and the first interlayer insulating layer 510. The first field dispersion layer 177a may be in contact with the lower protection layer 180 and the first interlayer insulating layer 510.

The first field dispersion layer 177a may be electrically connected to the source electrode 173. For example, the first field dispersion layer 177a may be connected to the first source electrode 173a. The first field dispersion layer 177a may include the same material as the first source electrode 173a and may be part of the same layer as the first source electrode 173a. The first field dispersion layer 177a may be formed simultaneously in the same process as the first source electrode 173a. A grain boundary between the first field dispersion layer 177a and the first source electrode 173a may not exist, and the first field dispersion layer 177a may be formed integrally with the first source electrode 173a to form a monolithic, or continuous, piece of material. However, the embodiments are not limited to this, and the first field dispersion layer 177a may be a separate component from the first source electrode 173a. Additionally, the first field dispersion layer 177a may be positioned in a different layer from the first source electrode 173a and may be formed in a different process. In some cases, the first field dispersion layer 177a may be electrically connected to the gate electrode 155. For example, an opening that overlaps the gate electrode 155 may be formed in the lower protection layer 180, and the first field dispersion layer 177a may be connected to the gate electrode 155 through the opening. In this case, the first field dispersion layer 177a may not be directly connected to (or integrally formed with) the source electrode 173.

The first field dispersion layer 177a may serve to disperse the electric field concentrated around the gate electrode 155, and may be an electrically conductive layer described as a field dispersion plate, or a field dispersing cover plate. If a high voltage is applied to drain 175 in a gate off state, an electric field may be concentrated on the gate electrode 155. When the electric field is concentrated on the gate electrode 155 and the gate semiconductor layer 152, a leakage current may increase and a breakdown voltage may decrease. The semiconductor device according to an embodiment includes the first field dispersion layer 177a and thus may disperse the electric field concentrated around the gate electrode 155. Accordingly, the leakage current may be reduced and the breakdown voltage may be increased. The first field dispersion layer 177a may have a convex shape that protrudes vertically where it covers the gate electrode 155.

The second field dispersion layer 177b may be positioned above the first interlayer insulating layer 510. The second field dispersion layer 177b may be positioned between the source electrode 173 and the drain electrode 175. The second field dispersion layer 177b may overlap with the gate electrode 155. The second field dispersion layer 177b may overlap with the first field dispersion layer 177a. The gate electrode 155 and the first field dispersion layer 177a may be covered by the second field dispersion layer 177b. The second field dispersion layer 177b may be positioned between the first interlayer insulating layer 510 and the second interlayer insulating layer 520. The second field dispersion layer 177b may be in contact with the first interlayer insulating layer 510 and the second interlayer insulating layer 520. The second field dispersion layer 177b may have a convex shape that protrudes vertically where it covers the gate electrode 155.

The width of the second field dispersion layer 177b may be wider than the width of the first field dispersion layer 177a. The second field dispersion layer 177b may entirely cover the first field dispersion layer 177a. That is, one end of the second field dispersion layer 177b may be positioned closer to the drain electrode 175 than a corresponding end of the first field dispersion layer 177a. However, the embodiments are not limited to this, and the width and the position relationship of the first field dispersion layer 177a and the second field dispersion layer 177b may be changed in various ways. The second field dispersion layer 177b may be electrically connected to the source electrode 173. For example, the second field dispersion layer 177b may be connected to the second source electrode 173b.

The second field dispersion layer 177b may include the same material as the second source electrode 173b and may be part of the same layer as the second source electrode 173b. The second field dispersion layer 177b may be formed simultaneously in the same process as the second source electrode 173b. A grain boundary between the second field dispersion layer 177b and the second source electrode 173b may not exist, and the second field dispersion layer 177b may be formed integrally with the second source electrode 173b to form a monolithic, or continuous, piece of material. However, the embodiments are not limited to this, and the second field dispersion layer 177b may be a separate component from the second source electrode 173b. Additionally, the second field dispersion layer 177b may be positioned in a different layer from the second source electrode 173b and may be formed in a different process. In some cases, the second field dispersion layer 177b may be electrically connected to the gate electrode 155. For example, the first field dispersion layer 177a may be connected to the gate electrode 155 through an opening formed in the lower protection layer 180, and the second field dispersion layer 177b may be connected to the first field dispersion layer 177a through an opening formed in the first interlayer insulating layer 510.

The third field dispersion layer 177c may be positioned above the second interlayer insulating layer 520. The third field dispersion layer 177c may be positioned between the source electrode 173 and the drain electrode 175. The third field dispersion layer 177c may overlap with the gate electrode 155. The third field dispersion layer 177c may overlap with the first field dispersion layer 177a and the second field dispersion layer 177b. The gate electrode 155, the first field dispersion layer 177a, and the second field dispersion layer 177b may be covered by the third field dispersion layer 177c.

The third field dispersion layer 177c may be wider than the width of the first field dispersion layer 177a and the second field dispersion layer 177b. The third field dispersion layer 177c may entirely cover the first field dispersion layer 177a and the second field dispersion layer 177b. In one embodiment, one end of the third field dispersion layer 177c may be positioned closer to the drain electrode 175 than the corresponding end of the second field dispersion layer 177b. However, the embodiments are not limited to this, and the width and the position relationship of the first field dispersion layer 177a, the second field dispersion layer 177b, and the third field dispersion layer 177c may be changed in various ways. The third field dispersion layer 177c may be electrically connected to the source electrode 173. For example, the third field dispersion layer 177c may be connected to the third source electrode 173c.

The third field dispersion layer 177c may include the same material as the third source electrode 173c and may be part of the same layer as the third source electrode 173c. The third field dispersion layer 177c may be formed simultaneously in the same process as the third source electrode 173c. A grain boundary between the third field dispersion layer 177c and the third source electrode 173c is not clear, and the third field dispersion layer 177c may be formed integrally with the third source electrode 173c to form a monolithic, or continuous, piece of material. However, the embodiments are not limited to this, and the third field dispersion layer 177c may be a separate component from the third source electrode 173c. Additionally, the third field dispersion layer 177c may be positioned in a different layer from the third source electrode 173c and may be formed in a different process.

In some cases, at least one of the field dispersion layers 177 may be omitted. For example, the semiconductor device according to an embodiment may include the first field dispersion layer 177a and the second field dispersion layer 177b, and may not include the third field dispersion layer 177c. Alternatively, the semiconductor device according to an embodiment may include the second field dispersion layer 177b and not include the first field dispersion layer 177a. Alternatively, the semiconductor device according to an embodiment may not include the first field dispersion layer 177a and the second field dispersion layer 177b.

Hereinafter, the content (at%) of the first element of the lower protection layer 180 and the interlayer insulating layer 500 of the semiconductor device according to an embodiment is described in detail with reference to FIG. 4 to FIG. 9.

FIG. 4 to FIG. 9 are graphs showing a concentration of a first element according to positions of a lower protection layer and an interlayer insulating layer of a semiconductor device according to some embodiments. FIG. 4 to 9 are graphs showing the content (at%) of the first element depending on the vertical direction (for example, the thickness direction of the channel layer 132) of the lower protection layer 180 of FIG. 1, the content (at%) of the first element depending on the vertical direction (for example, thickness direction of the channel layer 132) of the first interlayer insulating layer 510, and the content (at%) of the first element depending on the vertical direction (for example, the thickness direction of the channel layer 132) of the second interlayer insulating layer 520. In FIG. 4 to FIG. 9, the thickness is indicated by the vertical axis, and a distance away from the bottom surface of the lower protection layer 180 is indicated by the horizontal axis separately for each layer. The left-most side along the horizontal axis for each layer indicates a level closer to the bottom surface of the lower protection layer 180, and the right-most side along the horizontal axis for each layer indicates a level further from the bottom surface of the lower protection layer 180.

Referring further to FIG. 4 to FIG. 9, at least one of the lower protection layer 180, the first interlayer insulating layer 510, and the second interlayer insulating layer 520 of the semiconductor device according to some embodiments may contain a first element of different content (at%) as a distance away from the bottom surface of the lower protection layer 180 increases.

Referring to FIG. 4, the second content (at%) of the first element of the lower protection layer 180, the first content (at%) of the first element of the first interlayer insulating layer 510, and the third content (at%) of the first element of the second interlayer insulating layer 520 may increase as a distance away from the bottom surface of the lower protection layer 180 increases. In this case, the second content (at%) of the first element of the lower protection layer 180, the first content (at%) of the first element of the first interlayer insulating layer 510, and the third content (at%) of the first element of the second interlayer insulating layer 520 may increase at a constant rate as a distance away from the bottom surface of the lower protection layer 180 increases.

Accordingly, the second content (at%) of the first element above the lower protection layer 180 may be greater than the second content (at%) of the first element below the lower protection layer 180. For example, on the bottom surface 180_B of the lower protection layer 180, the second content (at%) of the first element may have a minimum value, and on the upper surface of the lower protection layer 180, the second content (at%) of the first element may have a maximum value.

The first content (at%) of the first element at the upper part of the first interlayer insulating layer 510 may be greater than the first content (at%) of the first element at the lower part of the first interlayer insulating layer 510. For example, on the bottom surface of the first interlayer insulating layer 510, the first content (at%) of the first element may have the minimum value, and on the top surface of the first interlayer insulating layer 510, the first content (at%) of the first element may have the maximum value.

In an embodiment, the first content (at%) of the first element of the first interlayer insulating layer 510 may be greater than the second content (at%) of the first element of the lower protection layer 180. For example, the first minimum value N1min of the first content (at%) of the first element of the first interlayer insulating layer 510 may be greater than the second maximum value N2max of the second content (at%) of the first element of the lower protection layer 180. The first maximum value N1max of the first content (at%) of the first element of the first interlayer insulating layer 510 may be greater than the second maximum value N2max of the second content (at%) of the first element of the lower protection layer 180. Additionally, the first minimum value N1min of the first content (at%) of the first element of the first interlayer insulating layer 510 may be greater than the second minimum value N2min of the second content (at%) of the first element of the lower protection layer 180. An overall content (at%) of the first element through the entirety of the first interlayer insulating layer 510 may be greater than an overall content (at%) of the first element through the entirety of the lower protection layer 180. In addition, there may be an abrupt jump in content (at%) of the first element at the interface between the top of the lower protection layer 180 and the bottom of the first interlayer insulating layer 510.

The third content (at%) of the first element at the upper part of the second interlayer insulating layer 520 may be greater than the third content (at%) of the first element at the lower part of the second interlayer insulating layer 520. For example, the third content (at%) of the first element on the bottom surface of the second interlayer insulating layer 520 may have a minimum value, and the third content (at%) of the first element on the upper surface of the second interlayer insulating layer 520 may have a maximum value.

In an embodiment, the third content (at%) of the first element of the second interlayer insulating layer 520 may be greater than or equal to the second content (at%) of the first element of the lower protection layer 180. For example, the third minimum value N3min of the third content (at%) of the first element of the second interlayer insulating layer 520 may be the same as or greater than the second maximum value N2max of the second content (at%) of the first element of the lower protection layer 180. In addition, the third maximum value N3max of the third content (at%) of the first element of the second interlayer insulating layer 520 may be greater than the second minimum value N2min of the second content (at%) of the first element of the lower protection layer 180. In the embodiment of FIG. 4, the third maximum value N3max of the third content (at%) of the first element of the second interlayer insulating layer 520 is greater than the second maximum value N2max of the second content (at%) of the first element of the lower protection layer 180, and the third minimum value N3min of the third content (at%) of the first element of the second interlayer insulating layer 520 is greater than the second minimum value N2min of the second content (at%) of the first element of the lower protection layer 180. In addition, there may be an abrupt jump (e.g., decrease) in content (at%) of the first element at the interface between the top of the first interlayer insulating layer 510 and the bottom of the second interlayer insulating layer 520.

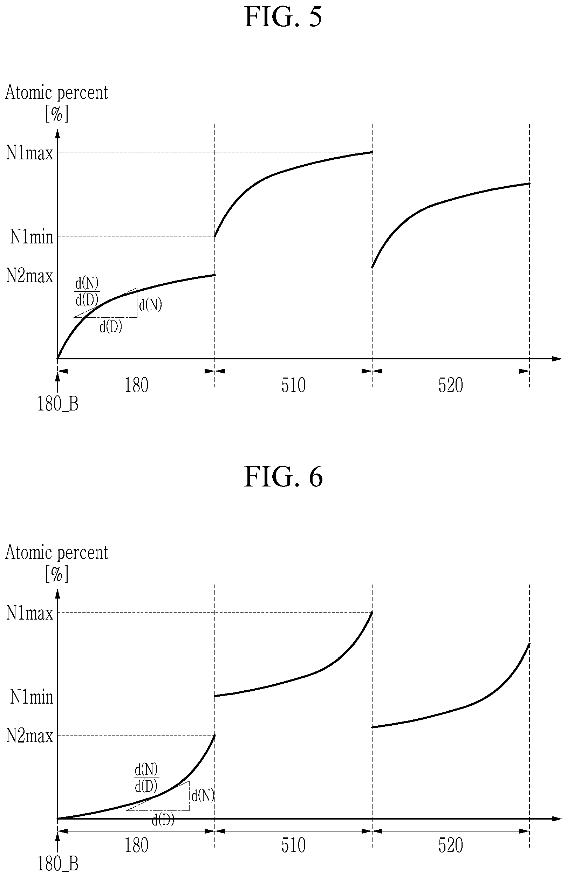

Referring to FIG. 5 and FIG. 6, the second content (at%) of the first element of the lower protection layer 180, the first content (at%) of the first element of the first interlayer insulating layer 510, and the third content (at%) of the first element of the second interlayer insulating layer 520 may increase as a distance away from the bottom surface of the lower protection layer 180 increases.

In some embodiments, as shown in FIG. 5, the increasing ratio d(N)/d(D) (also described herein as a gradient, or rate of increase) of the second content (at%) of the first element of the lower protection layer 180, the first content (at%) of the first element of the first interlayer insulating layer 510, and the third content (at%) of the first element of the second interlayer insulating layer 520 may decrease as a distance away from the bottom surface of the lower protection layer 180 increases. Here, the increasing ratio d(N)/d(D) of the second content (at%) of the first element of the lower protection layer 180 may mean the amount of the change in the content d(N) depending on the amount of the change in the distance d(D) (e.g., divided by the amount of change in the distance d(D)) in the vertical direction (e.g., the thickness direction of the channel layer 132). As shown in FIG. 5, the rate of increase d(N)/d(D) may be a slope of a tangent line of the graph showing the content (at%) depending on a position.

Also, as shown in FIG. 6, the increasing ratio d(N)/d(D) of the second content (at%) of the first element of the lower protection layer 180, the first content (at%) of the first element of the first interlayer insulating layer 510, and the third content (at%) of the first element of the second interlayer insulating layer 520 may increase as a distance away from the bottom surface of the lower protection layer 180 increases. Here, the increasing ratio d(N)/d(D) of the second content (at%) of the first element of the lower protection layer 180 may mean the amount of the change in the content d(N) depending on the amount of the change in the distance d(D) (e.g., divided by the amount of change in the distance d(D)) in the vertical direction (for example, the thickness direction of channel layer 132). As shown in FIG. 6, the rate of increase may be a slope of a tangent line of the graph showing content (at%) according to the position.

Even in the case of FIG. 5 and FIG. 6, the first content (at%) of the first element of the first interlayer insulating layer 510 may be greater than the second content (at%) of the first element of the lower protection layer 180. For example, the first minimum value N1min of the first content (at%) of the first element of the first interlayer insulating layer 510 may be greater than the second maximum value N2max of the second content (at%) of the first element of the lower protection layer 180. The first maximum value N1max of the first content (at%) of the first element of the first interlayer insulating layer 510 may be greater than the second maximum value N2max of the second content (at%) of the first element of the lower protection layer 180. Additionally, the third content (at%) of the first element of the second interlayer insulating layer 520 may be greater than or equal to the second content (at%) of the first element of the lower protection layer 180. Other relationships between content (at%) of the different layers in FIGS. 5 and 6 may be similar to or the same as those described above in connection with FIG. 4, as can be seen from the graphs, and so a detailed description thereof is omitted for sake of brevity.

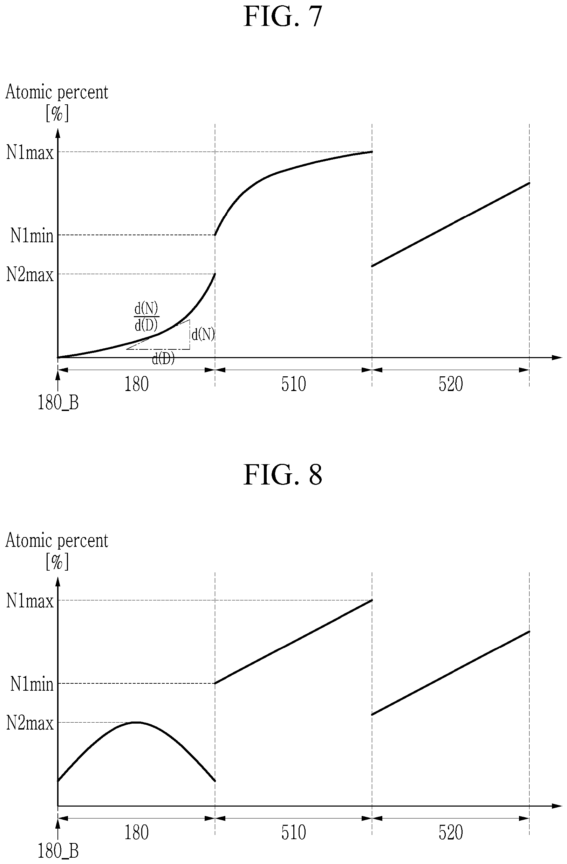

Referring to FIG. 7, at least one increasing ratio d(N)/d(D) among the second content (at%) of the first element of the lower protection layer 180, the first content (at%) of the first element of the first interlayer insulating layer 510, and the third content (at%) of the first element of the second interlayer insulating layer 520 may increase as the distance from the bottom surface of the lower protection layer 180 increases. In addition, another increasing ratio d(N)/d(D) among the second content (at%) of the first element of the lower protection layer 180, the first content (at%) of the first element of the first interlayer insulating layer 510, and the third content (at%) of the first element of the second interlayer insulating layer 520 may decrease as the distance away from the bottom surface of the lower protection layer 180 increases. In addition, another increasing ratio d(N)/d(D) among the second content (at%) of the first element of the lower protection layer 180, the first content (at%) of the first element of the first interlayer insulating layer 510, and the third content (at%) of the first element of the second interlayer insulating layer 520 may be constant as the distance away from the bottom surface of the lower protection layer 180.

For example, as shown in FIG. 7, the second content (at%) of the first element of the lower protection layer 180, the first content (at%) of the first element of the first interlayer insulating layer 510, and the third content (at%) of the first element of the second interlayer insulating layer 520 may increase as the distance away from the bottom surface 180_B of the lower protection layer 180 increases. The increasing ratio d(N)/d(D) of the second content (at%) of the first element of the lower protection layer 180 may decrease as it moves away from the bottom surface 180_B of the lower protection layer 180. Additionally, the increasing ratio d(N)/d(D) of the first content (at%) of the first element of the first interlayer insulating layer 510, may increase as it moves away from the bottom surface 180_B of the lower protection layer 180. Additionally, the increasing ratio (d(N)/d(D)) of the third content (at%) of the first element of the second interlayer insulating layer 520 may be constant as it moves away from the bottom surface 180_B of the lower protection layer 180. However, the increasing ratio d(N)/d(D) of the second content (at%) of the first element of the lower protection layer 180, the first content (at%) of the first element of the first interlayer insulating layer 510, and the third content (at%) of the first element of the second interlayer insulating layer 520 is not limited thereto and may be changed in various ways. Other relationships between content (at%) of the different layers in FIG. 7 may be similar to or the same as those described above in connection with FIG. 4, as can be seen from the graphs, and so a detailed description thereof is omitted for sake of brevity.

Referring to FIG. 8, the second content (at%) of the first element of the lower protection layer 180 may further include a portion that it decreases as a distance away from the bottom surface 180_B of the lower protection layer 180 increases.

For example, the lower protection layer 180 may include a portion where the second content (at%) of the first element increases as a distance away from the bottom surface 180_B of the lower protection layer 180 increases, and a portion where the second content (at%) of the first element decreases as a distance away from the bottom surface 180_B of the lower protection layer 180 increases. The second maximum value N2max of the second content (at%) of the first element of the lower protection layer 180 may be smaller than the first maximum value N1max of the first content (at%) of the first element of the first interlayer insulating layer 510. Additionally, the second maximum value N2max of the second content (at%) of the first element of the lower protection layer 180 may be less than the first minimum value N1min of the first content (at%) of the first element of the first interlayer insulating layer 510.

In some embodiments, the second content (at%) of the first element of the lower protection layer 180 is described as further including the portion that decreases as a distance away from the bottom surface 180_B of the lower protection layer 180 increases, but the embodiments are not limited thereto. For example, at least one of the second content (at%) of the first element of the lower protection layer 180, the first content (at%) of the first element of the first interlayer insulating layer 510, and the third content (at%) of the first element of the second interlayer insulating layer 520 may further include a part that has a content (at%) of a first element that decreases as a distance away from the bottom surface 180_B of the lower protection layer 180 increases.

In some embodiments, the second content (at%) of the first element of the lower protection layer 180 increases and then decreases as a distance away from the bottom surface 180_B of the lower protection layer 180 increases, and the second content (at%) of the first element on the bottom surface 180_B of the lower protection layer 180 may be substantially the same as the second content (at%) of the first element on the upper surface of the lower protection layer 180. However, the embodiments are not limited thereto, and the second content (at%) of the first element on the bottom surface 180_B of the lower protection layer 180 may be different from the second content (at%) of the first element on the upper surface of the lower protection layer 180. Other relationships between content (at%) of the different layers in FIG. 8 may be similar to or the same as those described above in connection with FIG. 4, as can be seen from the graphs, and so a detailed description thereof is omitted for sake of brevity.

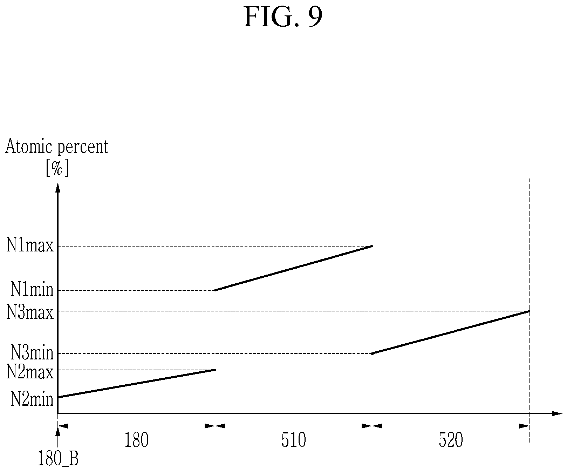

Referring to FIG. 9, the third content (at%) of the first element of the second interlayer insulating layer 520 may be smaller than the first content (at%) of the first element of the first interlayer insulating layer 510, for example throughout the entire thickness of each layer. For example, the third maximum value N3max of the third content (at%) of the first element of the second interlayer insulating layer 520 may be smaller than the first minimum value N1min of the first content (at%) of the first element of the first interlayer insulating layer 510. In addition, the third maximum value N3max of the third content (at%) of the first element of the second interlayer insulating layer 520 may be smaller than the first maximum value N1max of the first content (at%) of the first element of the first interlayer insulating layer 510. In addition, the third minimum value N3min of the third content (at%) of the first element of the second interlayer insulating layer 520 may be smaller than the first minimum value N1min of the first content (at%) of the first element of the first interlayer insulating layer 510.

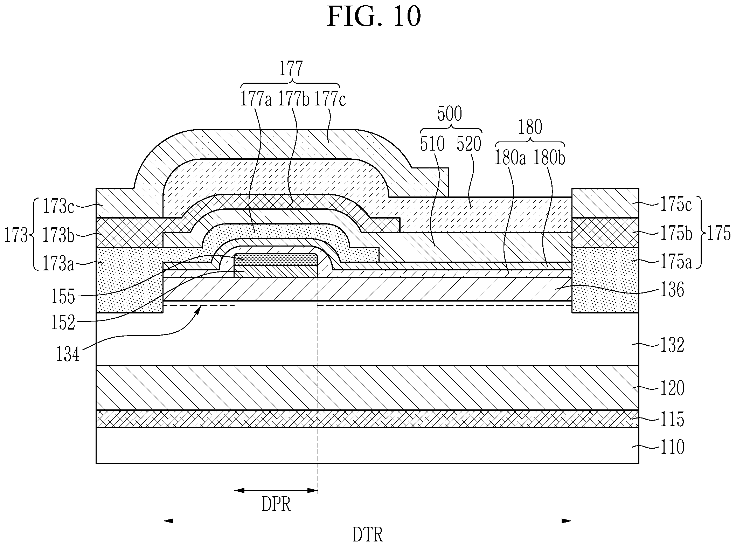

Additionally, the third content (at%) of the first element of the second interlayer insulating layer 520 may be larger than the second content (at%) of the first element of the lower protection layer 180, for example throughout the entire thickness of each layer. For example, the third minimum value N3min of the third content (at%) of the first element of the second interlayer insulating layer 520 may be greater than the second maximum value N2max of the second content (at%) of the first element of the lower protection layer 180. The third minimum value N3min of the third content (at%) of the first element of the second interlayer insulating layer 520 may be greater than the second minimum value N2min of the second content (at%) of the first element of the lower protection layer 180. Additionally, the third maximum value N3max of the third content (at%) of the first element of the second interlayer insulating layer 520 may be greater than the second maximum value N2max of the second content (at%) of the first element of the lower protection layer 180. Hereinafter, semiconductor devices according to some embodiments are described with reference to FIG. 10 to FIG. 13.

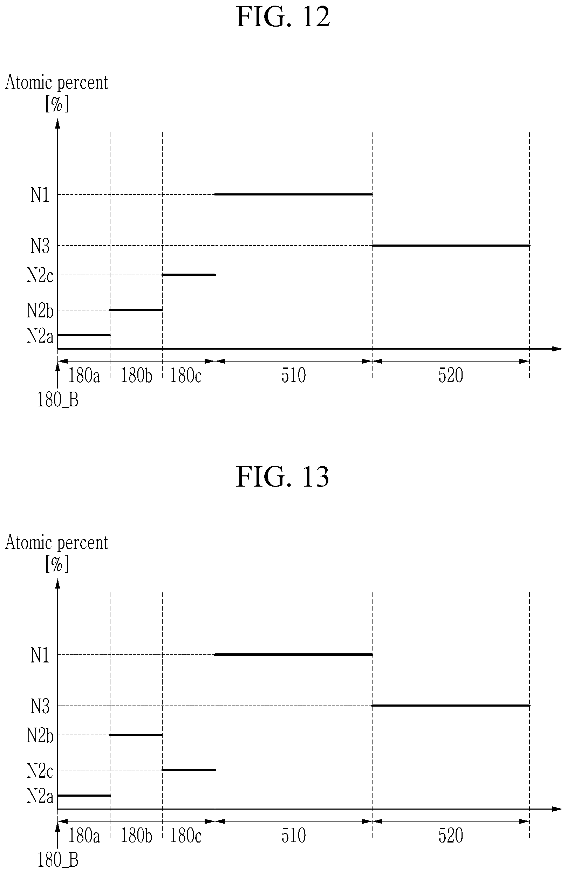

FIG. 10 and FIG. 11 are cross-sectional views showing a semiconductor device according to some embodiments. FIG. 12 and FIG. 13 are graphs showing a concentration of a first element according to positions of a lower protection layer and an interlayer insulating layer of a semiconductor device according to some embodiments. FIG. 12 and FIG. 13 are graphs showing the content (at%) of the first element according to the vertical direction (for example, the thickness direction of the channel layer 132) of the first to third sub-lower protection layers 180.

FIG. 10 to FIG. 13 are numerous variations of the semiconductor devices according to the embodiments shown in FIG. 1 to FIG. 3. The embodiments shown in FIG. 10 to FIG. 13 are many parts that are the same as the embodiments shown in FIG. 1 to FIG. 3 so that the descriptions thereof will be omitted and the differences will be mainly explained. Additionally, the same reference numerals are used for the same components as the previous embodiment.

First, referring to FIG. 10 and FIG. 11, a semiconductor device according to an embodiment may include a channel layer 132, a barrier layer 136 positioned on the channel layer 132, a gate electrode 155 positioned on the barrier layer 136, a gate semiconductor layer 152 positioned between the barrier layer 136 and the gate electrode 155, a lower protection layer 180 positioned on the barrier layer 136, an interlayer insulating layer 500 positioned on the lower protection layer 180, a source electrode 173 and a drain electrode 175 separated from each other on the channel layer 132, and a field dispersion layer 177 positioned on the lower protection layer 180.

The lower protection layer 180 according to some embodiments may include multiple layers sequentially stacked from the upper surface of the barrier layer 136.

For example, as shown in FIG. 10, the lower protection layer 180 may include a first lower protection layer 180a and a second lower protection layer 180b sequentially positioned from the upper surface of the barrier layer 136. The first lower protection layer 180a may be positioned above the barrier layer 136. The first lower protection layer 180a may cover the gate electrode 155. The second lower protection layer 180b may be positioned above the first lower protection layer 180a. The first and second lower protection layers 180a and 180b may be positioned between the barrier layer 136 and the first field dispersion layer 177a. The first lower protection layer 180a may be in contact with the barrier layer 136, and the second lower protection layer 180b may be in contact with the first field dispersion layer 177a.

As another example, as shown in FIG. 11, the lower protection layer 180 may include the first to third lower protection layers 180a to 180c sequentially positioned from the upper surface of the barrier layer 136. The first lower protection layer 180a may be positioned above the barrier layer 136. The first lower protection layer 180a may cover the gate electrode 155. The second lower protection layer 180b may be positioned above the first lower protection layer 180a. The third lower protection layer 180c may be positioned above the second lower protection layer 180b. The first to third lower protection layers 180a to 180c may be positioned between the barrier layer 136 and the first field dispersion layer 177a. The first lower protection layer 180a may be in contact with the barrier layer 136, and the third lower protection layer 180c may be in contact with the first field dispersion layer 177a.

Referring further to FIG. 12 and FIG. 13, the first to third lower protection layers 180a to 180c may include a first element and a second element different from the first element. Here, the first element may be nitrogen (N), and the second element may be silicon (Si). As an example, when the first to third lower protection layers 180a to 180c include silicon oxynitride (SiON), silicon carbon nitride (SiCN), silicon oxycarbonitride (SiOCN), silicon nitride (SiN), or a combination thereof, the first element may be nitrogen (N), and the second element may be silicon (Si).

In some embodiments, the first lower protection layer 180a may include the first element of the fourth content N2a (at%), the second lower protection layer 180b may include the first element of the fifth content N2b (at%), and the third lower Protection layer 180c may include the first element of sixth content N2c (at%). The contents (at%) of the first elements included in the first to third lower protection layers 180a to 180c may be different. For example, as shown in FIG. 12, the fourth content N2a(at%) of the first element of the first lower protection layer 180a may be smaller than the fifth content N2b(at%) of the first element of the second lower protection layer 180b. Additionally, the fifth content N2b(at%) of the first element of the second lower protection layer 180b may be smaller than the sixth content N2c(at%) of the first element of the third lower protection layer 180c. The sixth content N2c(at%) of the first element of the third lower protection layer 180c may be smaller than the first content N1(at%) of the first element of the first interlayer insulating layer 510. Additionally, the sixth content N2c(at%) of the first element of the third lower protection layer 180c may be smaller than the third content N3(at%) of the first element of the second interlayer insulating layer 520.

As another example, as shown in FIG. 13, the fifth content N2b(at%) of the first element of the second lower protection layer 180b may be greater than the sixth content N2c(at%) of the first element of the third lower protection layer 180c. The fifth content N2b(at%) of the first element of the second lower protection layer 180b may be smaller than the first content N1(at%) of the first element of the first interlayer insulating layer 510. Additionally, the sixth content N2c(at%) of the first element of the third lower protection layer 180c may be smaller than the third content N3(at%) of the first element of the second interlayer insulating layer 520. However, the embodiments are not limited thereto, the content of the first element of the first to third lower protection layers 180a to 180c may be changed in various ways within a smaller range than the content (at%) of the first element of the second interlayer insulating layer 520 and the content (at%) of the first element of the first interlayer insulating layer 510.

In the embodiment of FIG. 10 and FIG. 11, the lower protection layer 180 is described as consisting of two or three layers, but it is not limited thereto, the lower protection layer 180 may consist of four or more layers.

In FIG. 12 and FIG. 13, the content (at%) of the first element depending on the vertical direction (for example, the thickness direction of the channel layer 132) in the first to third lower protection layers 180a to 180c of the embodiment of FIG. 11 is described, but it may be equally applied to the first and second lower protection layers 180a and 180b of the embodiment of FIG. 10 of course.

Hereinafter, the semiconductor devices according to some embodiments are described with FIG. 14 to FIG. 18.

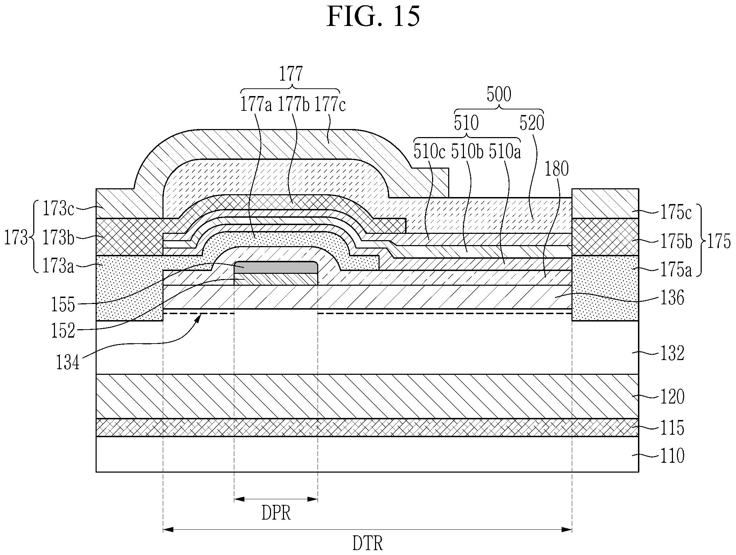

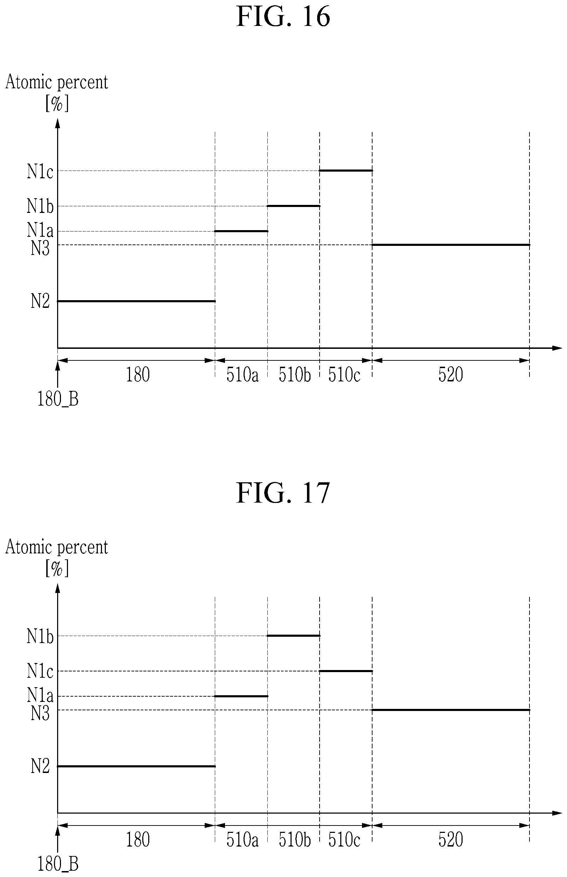

FIG. 14 and FIG. 15 are cross-sectional views showing a semiconductor device according to some embodiments. FIG. 16 to FIG. 18 are graphs showing a concentration of a first element according to positions of a lower protection layer and an interlayer insulating layer of a semiconductor device according to some embodiments. FIG. 16 to FIG. 18 are graphs showing the content (at%) of the first element according to the vertical direction (for example, the thickness direction of the channel layer 132) of the first to third sub-lower protection layers 180 of FIG. 15.

FIG. 14 to FIG. 18 are numerous variations of the semiconductor devices according to the embodiments shown in FIG. 1 to FIG. 3. The embodiments shown in FIG. 14 to FIG. 18 include many features that are the same as the embodiments shown in FIG. 1 to FIG. 3 so that the descriptions thereof will be omitted and the differences will be mainly explained. Additionally, the same or similar reference numerals are used for the same or similar components as the previous embodiments.

First, referring to FIG. 14 and FIG. 15, a semiconductor device according to an embodiment may include a channel layer 132, a barrier layer 136 positioned on the channel layer 132, a gate electrode 155 positioned on the barrier layer 136, a gate semiconductor layer 152 positioned between the barrier layer 136 and the gate electrode 155, a lower protection layer 180 positioned on the barrier layer 136, an interlayer insulating layer 500 positioned on the lower protection layer 180, a source electrode 173 and a drain electrode 175 separated from each other on the channel layer 132, and a field dispersion layer 177 positioned on the lower protection layer 180.

The first interlayer insulating layer 510 according to some embodiments may include multiple layers sequentially stacked from the upper surface of the lower protection layer 180.

For example, as shown in FIG. 14, the first interlayer insulating layer 510 may include a first sub-interlayer insulating layer 510a and a second sub-interlayer insulating layer 510b sequentially positioned from the upper surface of the lower protection layer 180 and the first field dispersion layer 177a. The first sub-interlayer insulating layer 510a may be positioned above the lower protection layer 180 and the first field dispersion layer 177a. The first sub-interlayer insulating layer 510a may cover the gate electrode 155. Additionally, the first sub-interlayer insulating layer 510a may cover the first field dispersion layer 177a. The second sub-interlayer insulating layer 510b may be positioned above the first sub-interlayer insulating layer 510a. The first and second sub-interlayer insulating layers 510a and 510b may be positioned between the first field dispersion layer 177a and the second field dispersion layer 177b. The first sub-interlayer insulating layer 510a may be in contact with the first field dispersion layer 177a and the lower protection layer 180, and the second sub-interlayer insulating layer 510b may be in contact with the second field dispersion layer 177b and the second interlayer insulating layer 520.

As another example, as shown in FIG. 15, the first interlayer insulating layer 510 may include first to third sub-interlayer insulating layers 510a to 510c sequentially positioned from the upper surface of the lower protection layer 180 and the upper surface of the first field dispersion layer 177a. The first sub-interlayer insulating layer 510a may be positioned above the lower protection layer 180 and the first field dispersion layer 177a. The first sub-interlayer insulating layer 510a may cover the gate electrode 155. The first sub-interlayer insulating layer 510a may cover the first field dispersion layer 177a. The second sub-interlayer insulating layer 510b may be positioned above the first sub-interlayer insulating layer 510a. The third sub-interlayer insulating layer 510c may be positioned above the second sub-interlayer insulating layer 510b. The first to third sub-interlayer insulating layers 510a to 510c may be positioned between the first field dispersion layer 177a and the second field dispersion layer 177b. The first sub-interlayer insulating layer 510a may be in contact with the first field dispersion layer 177a and the lower protection layer 180, and the third sub-interlayer insulating layer 510c may be in contact with the second field dispersion layer 177b and the second interlayer insulating layer 520.

In the embodiment of FIG. 14 and FIG. 15, the first interlayer insulating layer 510 is described as consisting of two or three layers, but it is not limited thereto, the first interlayer insulating layer 510 may consist of four or more layers. In the various embodiments, different layers (e.g., the lower protection layer 180, or the first interlayer insulating layer 510 as discussed above) may include a plurality of sub-layers. Each sub-layer may have different contents of a first element (e.g., higher or lower content). Nonetheless, in the various embodiments, each sub-layer extends horizontally to be disposed in an area covering one or more layers of the field dispersion layer 177, an area adjacent to the source electrode 173, and an area adjacent to the drain electrode 175. Each sub-layer may be continuously formed through these areas in some embodiments. Also, as can be seen in the various figures, the lower protection layer 180, the first interlayer insulating layer 510, and the second interlayer insulating layer may be stacked in an interleaved manner with the first through third field dispersion layers 177a-177c.

Referring further to FIG. 16 to FIG. 18, the first to third sub-interlayer insulating layers 510a to 510c may include a first element and a second element different from the first element. Here, the first element may be nitrogen (N), and the second element may be silicon (Si). As an example, if the first to third sub-interlayer insulating layers 510a to 510c include silicon oxynitride (SiON), silicon carbon nitride (SiCN), silicon oxycarbonitride (SiOCN), silicon nitride (SiN), or a combination thereof, the first element may be nitrogen (N), and the second element may be silicon (Si).

In some embodiments, the first sub-interlayer insulating layer 510a may include the first element of a seventh content N1a (at%), and the second sub-interlayer insulating layer 510b may include the first element of an eighth content N1b (at%). and the third sub-interlayer insulating layer 510c may include the first element of a ninth content N1c (at%).

At this time, the contents (at%) of the first elements included in the first to third sub-interlayer insulating layers 510a to 510c may be different. For example, as shown in FIG. 16, the seventh content N1a (at%) of the first element of the first sub-interlayer insulating layer 510a may be smaller than the eighth content N1b (at%) of the first element of the second sub-interlayer insulating layer 510b. Additionally, the eighth content N1b(at%) of the first element of the second sub-interlayer insulating layer 510b may be smaller than the ninth content N1c(at%) of the first element of the third sub-interlayer insulating layer 510c. The seventh content N1a (at%) of the first element of the first sub-interlayer insulating layer 510a may be larger than the second content (at%) of the first element of the lower protection layer 180. Additionally, the seventh content N1a (at%) of the first element of the first sub-interlayer insulating layer 510a may be greater than the third content (at%) of the first element of the second interlayer insulating layer 520.

As another example, as shown in FIG. 17, the eighth content N1b(at%) of the first element of the second sub-interlayer insulating layer 510b may be greater than the ninth content N1c(at%) of the first element of the third sub-interlayer insulating layer 510c. The eighth content N1b (at%) of the first element of the second sub-interlayer insulating layer 510b may be greater than the second content (at%) of the first element of the lower protection layer 180. Additionally, the ninth content N1c (at%) of the first element of the third sub-interlayer insulating layer 510c may be greater than the second content (at%) of the first element of the lower protection layer 180. However, the embodiments are not limited thereto, the content of the first element of the first to third sub-interlayer insulating layers 510a to 510c may be changed in various ways within a range larger than the content (at%) of the first element of the second interlayer insulating layer 520 and the content (at%) of the first element of the lower protection layer 180.

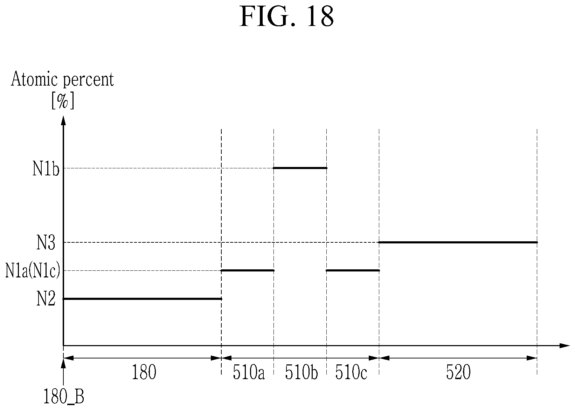

As another example, referring to FIG. 18, the seventh content N1a (at%) of the first element of the first sub-interlayer insulating layer 510a and the ninth content N1c (at%) of the first element of the third sub-interlayer insulating layer 510c may be smaller than the eighth content N1b(at%) of the first element of the second sub-interlayer insulating layer 510b. Therefore, the seventh content N1a (at%) of the first element of the first sub-interlayer insulating layer 510a and the ninth content N1c (at%) of the first element of the third sub-interlayer insulating layer 510c may be smaller than content N3(at%) of the third of the first element of the second interlayer insulating layer 520. However, even in this case, the seventh content N1a(at%) of the first element of the first sub-interlayer insulating layer 510a and the ninth content N1 c(at%) of the first element of the third sub-interlayer insulating layer 510c may be larger than the second content (at %) of the first element of the lower protection layer 180.

In FIG. 16 to FIG. 18, the content (at%) of the first element according to the vertical direction (for example, the thickness direction of the channel layer 132) of the first to third sub-interlayer insulating layers 510a to 510c of the embodiment of FIG. 15 is described, but these examples may be equally applied to the first and second sub-interlayer insulating layers 510a and 510b of the embodiment of FIG. 14.

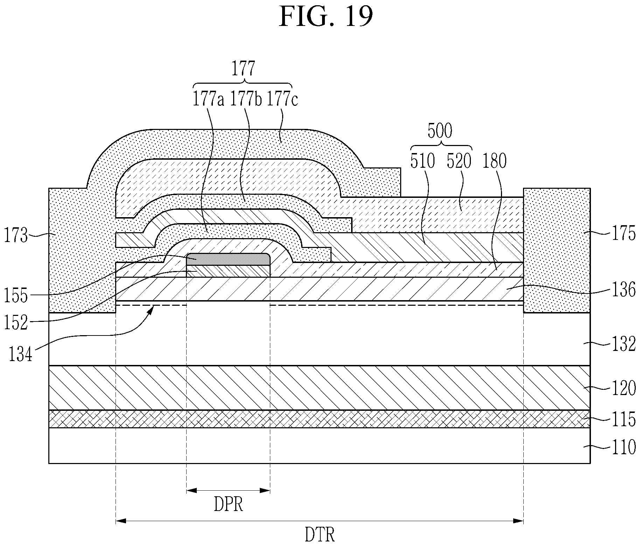

In the embodiment of FIG. 14 to FIG. 18, the second interlayer insulating layer 520 is shown as being composed of a single layer, but it is not limited thereto. For example, the second interlayer insulating layer 520 may be composed of multiple layers including the first elements of the different contents (at%), such as the first interlayer insulating layer 510, in the embodiment of FIG. 14 to FIG. 18. Also, although a content (at%) for each layer is shown in FIGS. 14-18 without referring to different alternatives for the content distribution throughout the layer, similar content profiles as depicted in FIGS. 4-9 may be used in the embodiments of FIG. 14 to FIG. 18 (as well as FIGS. 19 and 20, described in greater detail below).

Hereinafter, a semiconductor device according to an embodiment is described with reference to FIG. 19.

FIG. 19 is a cross-sectional view showing a semiconductor device according to some embodiments.

Referring to FIG. 19, the semiconductor device according to some embodiments may include the source electrode 173 and the drain electrode 175 positioned on the channel layer 132.

In some embodiments, each of the source electrode 173 and the drain electrode 175 may be formed of a single layer. For example, the side of the source electrode 173 and the side of the drain electrode 175 may be in contact with the channel layer 132, the barrier layer 136, the lower protection layer 180, the first interlayer insulating layer 510, and the second interlayer insulating layer 520. The source electrode 173 and the drain electrode 175 may be spaced apart from each other, and the gate electrode 155 and the gate semiconductor layer 152 may be positioned between the source electrode 173 and the drain electrode 175.

The upper-most surface of the source electrode 173 and the upper-most surface of the drain electrode 175 may be positioned at a higher level than the upper surface of the second interlayer insulating layer 520 at a horizontal location where the second interlayer insulating layer 520 contacts each of the source electrode 173 and the of the drain electrode 175, but the embodiments are not limited thereto. For example, the upper surface of the source electrode 173 and the upper surface of the drain electrode 175 may be positioned farther from the upper surface of the substrate 110 than the upper surface of the second interlayer insulating layer 520 at a horizontal location where the second interlayer insulating layer 520 contacts each of the source electrode 173 and the of the drain electrode 175.

In some embodiments, the first to third field dispersion layers 177a to 177c may be connected to the source electrode 173. The first to third field dispersion layers 177a to 177c may include the same material as the source electrode 173 and may be integrally formed with the source electrode 173.

Hereinafter, a semiconductor device according to an embodiment is described with reference to FIG. 20.

FIG. 20 is a cross-sectional view showing a semiconductor device according to an embodiment.

Referring to FIG. 20, the semiconductor device according to some embodiments includes a channel layer 132, a barrier layer 136 positioned on the channel layer 132, a gate electrode 155 positioned on the barrier layer 136, a gate semiconductor layer 152 positioned between the barrier layer 136 and the gate electrode 155, a source electrode 173 and a drain electrode 175 spaced apart from each other on the channel layer 132, a lower protection layer 180 positioned on the barrier layer 136, a middle protection layer 190 positioned on the lower protection layer 180, an interlayer insulating layer 500 positioned on the middle protection layer 190, and a field dispersion layer 177 positioned on the middle protection layer 190.

The middle protection layer 190 may be positioned above the lower protection layer 180. The middle protection layer 190 may cover the sides of the source electrode 173 and the drain electrode 175. For example, the middle protection layer 190 may cover the sides of the first source electrode 173a, the second source electrode 173b, the first drain electrode 175a, and the second drain electrode 175b. Additionally, at least a portion of the middle protection layer 190 may cover upper surfaces of the source electrode 173 and the drain electrode 175 (e.g., upper surfaces of the first source electrode 173a and the first drain electrode 175a).

The gate electrode 155 of the semiconductor device according to some embodiments may be connected to the gate semiconductor layer 152 through the lower protection layer 180 and the middle protection layer 190.

In some embodiments, the gate electrode 155 may penetrate the lower protection layer 180 and the middle protection layer 190. For example, the gate electrode 155 may penetrate the lower protection layer 180 and the middle protection layer 190 above the gate semiconductor layer 152. Accordingly, at least a portion of the side of the gate electrode 155 may be in contact with the lower protection layer 180 and the middle protection layer 190. The gate electrode 155 may overlap with the gate semiconductor layer 152 in the vertical direction (for example, the thickness direction of the channel layer 132). The bottom surface of the gate electrode 155 may be in contact with the top surface of the gate semiconductor layer 152. The gate electrode 155 may be positioned on at least a portion of the gate semiconductor layer 152. For example, the gate electrode 155 may be positioned on a portion of the gate semiconductor layer 152 (e.g., to contact a portion of the top surface of the gate semiconductor layer 152), and the lower protection layer 180 may be positioned on the remaining portion of the gate semiconductor layer 152 (e.g., to contact the remaining portion of the top surface of the gate semiconductor layer 152). Therefore, the upper surface of the gate semiconductor layer 152 may contact the gate electrode 155 and the lower protection layer 180. However, the embodiments are not limited thereto, and a top surface of the gate semiconductor layer 152 may completely overlap with a bottom surface of the gate electrode 155.

In some embodiments, the first field dispersion layer 177a may be positioned above the middle protection layer 190. For example, the first field dispersion layer 177a may be positioned between the gate electrode 155 and the drain electrode 175. Although not shown in the drawing, the first field dispersion layer 177a may be connected to the gate electrode 155 or the source electrode 173. However, the embodiments are not limited thereto, the first field dispersion layer 177a may not be connected to the gate electrode 155 and the source electrode 173. Additionally, the first field dispersion layer 177a may extend in one direction. For example, the first field dispersion layer 177a may extend in a direction parallel to the gate electrode 155, the source electrode 173, and the drain electrode 175.

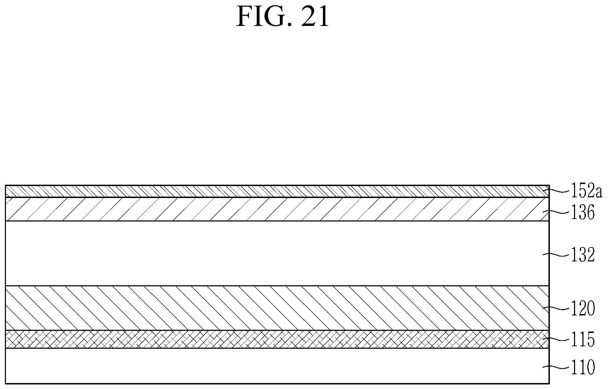

Hereinafter, a method of manufacturing a semiconductor device according to an embodiment is described with reference to FIG. 21 to FIG. 30.

FIG. 21 to FIG. 30 are process cross-sectional views shown according to a process order of manufacturing a semiconductor device according to an embodiment.

First, as shown in FIG. 21, a seed layer 115, a buffer layer 120, a channel layer 132, a barrier layer 136, and a gate semiconductor material layer 152a may be formed sequentially on a substrate 110.

The substrate 110 may include a semiconductor material. For example, the substrate 110 may include sapphire, Si, SiC, AIN, GaN, or combinations thereof. The substrate 110 may be a silicon on insulator (SOI) substrate. However, the material of the substrate 110 is not limited to this, and any generally-used substrate may be applied.

The seed layer, buffer layer 120, the channel layer 132, the barrier layer 136, and the gate semiconductor material layer 152a may be formed sequentially, for example, using an epitaxial growth method. The seed layer 115 may be formed on the substrate 110 first, and the buffer layer 120 may be formed on the seed layer 115. Next, the channel layer 132 may be formed on the buffer layer 122, the barrier layer 136 may be formed on the channel layer 132, and the gate semiconductor material layer 152a may be formed on the barrier layer 136. Although not shown, the buffer layer 120 may include a super lattice layer and a high-resistance layer. For example, a super lattice layer and a high-resistance layer may be formed on the seed layer 115 of the semiconductor device according to an embodiment. In this case, the super lattice layer and the high-resistance layer may be positioned between the buffer layer 120 and the channel layer 132.

Two or more of the seed layer 115, the buffer layer 120, the channel layer 132, the barrier layer 136, and the gate semiconductor material layer 152a may be made of the same base semiconductor material. However, the material composition ratio of each layer may be different considering the role of each layer and the performance required for the semiconductor device. The seed layer, buffer layer 120, the channel layer 132, the barrier layer 136, and the gate semiconductor material layer 152a may include one or more material selected from Group III-V materials, such as nitrides including Al, Ga, In, B, or a combination thereof. The seed layer, buffer layer 120, the channel layer 132, the barrier layer 136, and the gate semiconductor material layer 152a may be AlₓIn_{y}Ga_{(1-x-y)}N (0≤x≤1, 0≤y≤1, x+y≤1). For example, the seed layer 115, the buffer layer 120, the channel layer 132, the barrier layer 136, and the gate semiconductor material layer 152a may include AlN, GaN, InN, InGaN, AlGaN, AlInN, AlInGaN, or a combination thereof. The barrier layer 136 may include a material having a different energy band gap than the channel layer 132. The barrier layer 136 may have a higher energy band gap than the channel layer 132. The gate semiconductor material layer 152a may include a material having a different energy band gap than the barrier layer 136.

As an example, the substrate 110 may include Si, the seed layer 115 may include AlN, and the buffer layer 120 may include GaN. The channel layer 132 may include GaN, and the barrier layer 136 may include AlGaN. The channel layer 132 and the barrier layer 136 may or may not be impurity doped. The gate semiconductor material layer 152a may include GaN and may be doped with an impurity. The gate semiconductor material layer 152a may be doped with a P-type impurity, for example, magnesium (Mg).

As the lattice structure of Si and the lattice structure of GaN are different, it may not be easy to grow the channel layer 132 made of GaN directly on the substrate 110 made of Si. In the method of manufacturing the semiconductor device according to an embodiment, by first forming the seed layer 121 and the buffer layer 122 on the substrate 110 and then forming the channel layer 132, the lattice structure of the channel layer 132 may be formed stably.

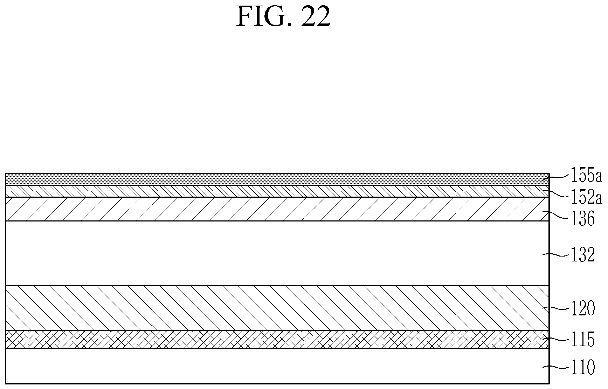

As shown in FIG. 22, the gate electrode material layer 155a may be formed on the gate semiconductor material layer 152a. The gate semiconductor material layer 152a is positioned between the barrier layer 136 and the gate electrode material layer 155a.

The gate electrode material layer 155a may be formed using a deposition process. For example, the gate electrode material layer 155a may be formed using at least one of a physical vapor deposition (PVD), a thermal chemical vapor deposition (a thermal CVD), a low pressure chemical vapor deposition (LP-CVD), a plasma enhanced chemical vapor deposition (PE-CVD), or an atomic layer deposition (ALD) technologies, but it is not limited thereto.

The gate electrode material layer 155a may include a conductive material. For example, the gate electrode material layer 155a may include a metal, a metal alloy, a conductive metal nitride, a metal silicide, a doped semiconductor material, a conductive metal oxide, or a conductive metal oxynitride, the like. For example, the gate electrode material layer 155a may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium( Os), silver (Ag), gold (Au), zinc (Zn), vanadium (V), or combination thereof, but it is not limited thereto. The gate electrode material layer 155a may be made of a single layer or multiple layers.

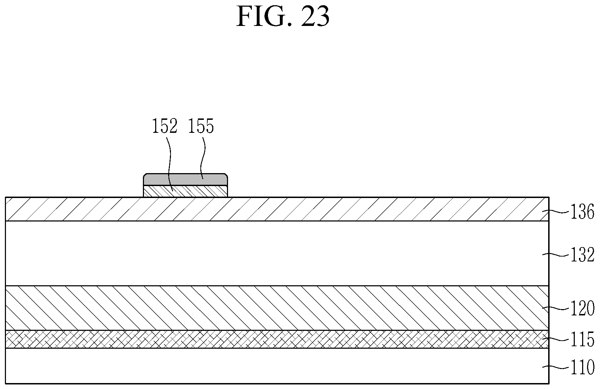

Next, as shown in FIG. 23, by patterning the gate electrode material layer 155a and the gate semiconductor material layer 152a by using a photo and etching process, the gate electrode 155 and the gate semiconductor layer 152 may be formed.

For example, a hard mask layer and a photoresist layer may be formed sequentially on the gate electrode material layer 155a. A photoresist pattern may be formed by patterning the photoresist layer by using a photo process. The hard mask pattern may be formed by etching the hard mask layer using the photoresist pattern as a mask. At this time, at least part of the gate electrode material layer 155a may be removed during the process of etching the hard mask layer. Subsequently, by etching the gate semiconductor material layer 152a by using the hard mask pattern as a mask, at least a portion of the gate semiconductor material layer 152a may be removed. Accordingly, the remaining portion of the gate electrode material layer 155a may become the gate electrode 155. Additionally, the portion of gate semiconductor material layer 152a that remains may become gate semiconductor layer 152. The gate semiconductor layer 152 is positioned between the barrier layer 136 and the gate electrode 155. The gate electrode 155 may be Schottky-contacted or ohmic-contacted to the gate semiconductor layer 152.

By patterning the gate semiconductor material layer 152a and the gate electrode material layer 155a by using the same mask, the gate semiconductor layer 152 and the gate electrode 155 may have the same pattern. That is, the gate semiconductor layer 152 and the gate electrode 155 may have the same planar shape. In a cross-section view, the gate semiconductor layer 152 and the gate electrode 155 may have the same width. The gate semiconductor layer 152 may completely overlap with the gate electrode 155 in the vertical direction, and the upper surface of the gate semiconductor layer 152 may be entirely covered by the gate electrode 155, but the embodiments are not limited thereto. For example, the gate semiconductor layer 152 and the gate electrode 155 may only partially overlap in the vertical direction.

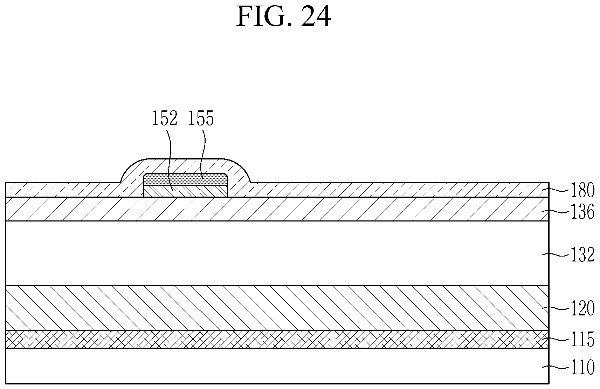

As shown in FIG. 24, a lower protection layer 180 may be formed on the barrier layer 136 and the gate electrode 155. The lower protection layer 180 may be formed using a deposition process. The lower protection layer 180 may be positioned above the barrier layer 136 and the gate electrode 155. The lower protection layer 180 may cover the upper and side surfaces of the gate electrode 155 and the side surfaces of the gate semiconductor layer 152. The bottom surface of the lower protection layer 180 may be in contact with the barrier layer 136 and the gate electrode 155. Accordingly, the barrier layer 136, the gate semiconductor layer 152, and the gate electrode 155 may be protected by the lower protection layer 180.

In an embodiment, the lower protection layer 180 may include an insulating material. For example, the lower protection layer 180 may include silicon oxide (SiO₂), silicon carbon oxide (SiOC), or a combination thereof. Also, the lower protection layer 180 may include silicon oxynitride (SiON), silicon carbon nitride (SiCN), silicon oxycarbonitride (SiOCN), silicon nitride (SiN), or a combination thereof. As another example, the lower protection layer 180 may include a material such as aluminum oxide (Al₂O₃).

In an embodiment, the lower protection layer 180 may include a first element and a second element that is different from the first element. Here, the first element may be nitrogen (N), and the second element may be silicon (Si). For example, if the lower protection layer 180 includes silicon oxynitride (SiON), silicon carbon nitride (SiCN), silicon oxycarbonitride (SiOCN), silicon nitride (SiN), or a combination thereof, the first element may be nitrogen (N), and the second element may be silicon (Si).

At this time, the lower protection layer 180 may include the first element of a second content (at%). Here, the first element of the second content (at%) of the lower protection layer 180 may mean the content (at%) of the first element for the entire content of the lower protection layer 180. For example, if the lower protection layer 180 includes silicon oxynitride (SiON), the second content (at%) may be the content (at%) of nitrogen(N) for the entire content of silicon (Si), nitrogen (N), and oxygen (O) of the lower protection layer 180. As another example, if the lower protection layer 180 includes silicon nitride (SiN), the second content (at%) may be the content (at%) of nitrogen (N) for the entire content of silicon (Si) and nitrogen (N) in the lower protection layer 180. For example, the second content (at%) of the first element of the lower protection layer 180 may be 0 at% or more and less than about 1 at%. For example, when the lower protection layer 180 includes silicon oxynitride (SiON), the second content (at%) of nitrogen (N) in the lower protection layer 180 may be greater than 0 at% and less than about 1 at%. On the other hand, when the lower protection layer 180 includes silicon oxide (SiO₂), the second content (at%) of nitrogen (N) of the lower protection layer 180 may be 0 at%.

In an embodiment, the lower protection layer 180 was described as being formed of a single layer, but it is not limited thereto. For example, the lower protection layer 180 may be comprised of multiple layers sequentially stacked on the barrier layer 136.

The sides of the gate electrode 155 and the gate semiconductor layer 152 may be covered by the lower protection layer 180. The sides of the gate electrode 155 and the gate semiconductor layer 152 may be in contact with the lower protection layer 180. A step may occur between the portion of the lower protection layer 180 that overlaps with the gate electrode 155 and the gate semiconductor layer 152 and the remaining portion. However, the embodiments are not limited to this, and in some cases, the upper surface of the lower protection layer 180 may be entirely flat. For example, if the thickness of the lower protection layer 180 is relatively thick, a step may not occur between the portion of the lower protection layer 180 that overlaps the gate electrode 155 and the gate semiconductor layer 152 and the remaining portion.

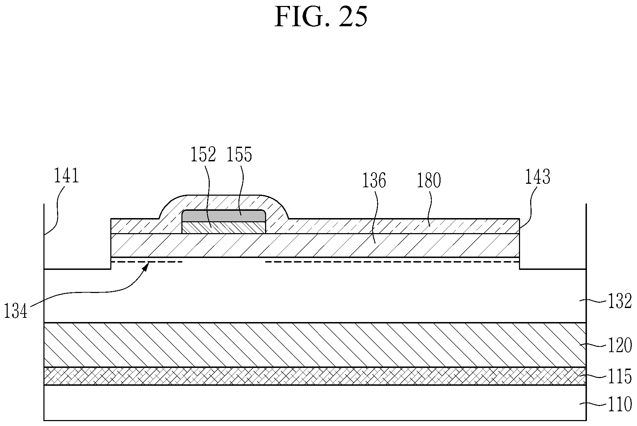

As shown in FIG. 25, a first trench 141 and a second trench 143 may be formed by patterning the lower protection layer 180 by using a photo and etching processes. At this time, not only the lower protection layer 180 but also the barrier layer 136 and channel layer 132 may be patterned together.

For example, a photoresist pattern may be formed on the lower protection layer 180, and the lower protection layer 180, the barrier layer 136, and the channel layer 132 may be sequentially etched using the photoresist pattern as a mask. At this time, the lower protection layer 180 and the barrier layer 136 may be fully penetrated by the first trench 141 and the second trench 143, and the upper surface of the channel layer 132 may be recessed. The channel layer 132 may not be fully penetrated by the first trench 141 or the second trench 143. That is, the depth at which the upper surface of the channel layer 132 is recessed may be smaller than the entire thickness of the channel layer 132. At this time, the depth at which the upper surface of the channel layer 132 is recessed may be much smaller than the entire thickness of the channel layer 132. Additionally, the depth at which the upper surface of the channel layer 132 is recessed may be smaller than the thickness of the barrier layer 136. However, embodiments are not limited thereto, and the depth at which the upper surface of the channel layer 132 is recessed may be changed in various ways.

By the first trench 141 and the second trench 143, the side surfaces of the lower protection layer 180 and the barrier layer 136 may be exposed to the outside, and the upper and side surfaces of the channel layer 132 may be exposed. The channel layer 132 may form the bottom surface and the sidewall of the first trench 141 and the second trench 143, and the barrier layer 136 may form the sidewall of the first trench 141 and the second trench 143.

The first trench 141 and the second trench 143 may be spaced apart from each other. The first trench 141 and the second trench 143 may be positioned on both sides of the gate electrode 155. The first trench 141 may be positioned on one side of the gate electrode 155 to be spaced apart from the gate electrode 155. The second trench 143 may be positioned on the other side of the gate electrode 155 to be spaced apart from the gate electrode 155. The distance that the first trench 141 is separated from the gate electrode 155 may be smaller than the distance that the second trench 143 is separated from the gate electrode 155. The shapes such as a width and a depth of the first trench 141 and the second trench 143 are shown to be similar, but are not limited thereto. The shapes of the first trench 141 and the second trench 143 may be changed in various ways. The channel layer 132, the barrier layer 136, and the lower protection layer 180 may be located on the outer side of the first trench 141 and the second trench 143.

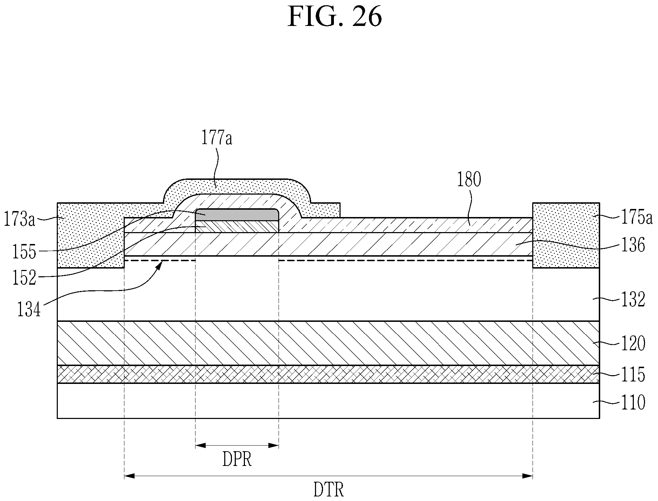

As shown in FIG. 26, a conductive material may be deposited in the first trench 141 and the second trench 143 and patterned to form a first source electrode 173a and a first drain electrode 175a.

The first source electrode 173a and the first drain electrode 175a may include a conductive material. For example, the first source electrode 173a and the first drain electrode 175a may include metal, metal alloy, conductive metal nitride, metal silicide, doped semiconductor material, conductive metal oxide, or conductive metal oxynitride. The first source electrode 173a and the first drain electrode 175a may be made of a single layer or multiple layers. For example, a plurality of conductive layers including different materials can be stacked and then patterned to form the first source electrode 173a and the first drain electrode 175a. At this time, the plurality of conductive layers may be etched simultaneously or sequentially using one mask pattern. For example, Ti, Al, Ti, and TiN may be sequentially stacked and then patterned to form the first source electrode 173a and the first drain electrode 175a. At this time, the thicknesses of the four conductive layers constituting the first source electrode 173a and the first drain electrode 175a may be similar to or different from each other. For example, a layer made of Al may be relatively thick compared to other layers.

The first source electrode 173a may be formed to fill the interior of the first trench 141. Within the first trench 141, the first source electrode 173a may be in contact with the channel layer 132 and the barrier layer 136. The first source electrode 173a may be in contact with the side surfaces of the channel layer 132 and the barrier layer 136. The first source electrode 173a may cover the sides of the channel layer 132 and the barrier layer 136. The first source electrode 173a may be electrically connected to the channel layer 132 through the first trench 141. The upper surface of the first source electrode 173a may protrude from the upper surface of the lower protection layer 180.

The first drain electrode 175a may be formed to fill the interior of the second trench 143. Within the second trench 143, the first drain electrode 175a may be in contact with the channel layer 132 and the barrier layer 136. The first drain electrode 175a may be in contact with the sides of the channel layer 132 and the barrier layer 136. The first drain electrode 175a may cover the sides of the channel layer 132 and the barrier layer 136. The first drain electrode 175a may be electrically connected to the channel layer 132 through the second trench 143. The upper surface of the first drain electrode 175a may protrude from the upper surface of the lower protection layer 180.

The first source electrode 173a and the first drain electrode 175a may be in ohmic-contact with the channel layer 132. The region in contact with the first source electrode 173a and the first drain electrode 175a within the channel layer 132 may be doped at a relatively high concentration compared to other regions. For example, the channel layer 132 may be doped by an ion implant process, an annealing process, etc. However, the embodiments not limited thereto, and the doping process of the channel layer 132 may be comprised of various other processes. The doping process of the channel layer 132 may be performed before forming the first source electrode 173a and the first drain electrode 175a. In some cases, the channel layer 132 may not be doped.

Inside the channel layer 132, a two-dimensional electron gas 134 may be formed in a portion adjacent to the barrier layer 136. The two-dimensional electron gas 134 may be positioned at the interface between the channel layer 132 and the barrier layer 136. The two-dimensional electron gas 134 may be positioned in a drift region DTR between the first source electrode 173a and the first drain electrode 175a. A depletion region DPR may be formed within the channel layer 132 by the gate semiconductor layer 152 having a different energy band gap from the barrier layer 136. Accordingly, the semiconductor device according to an embodiment may have a normally off characteristic. For example, the semiconductor device according to an embodiment may be a normally off high electron mobility transistor (HEMT). In the gate off state, the two-dimensional electron gas 134 may be positioned within the drift region DTR excluding the depletion region DPR of the channel layer 132. In the gate-on state, the flow of the two-dimensional electron gas 134 continues within the depletion region DPR, allowing the two-dimensional electron gas 134 to be positioned overall within the drift region DTR.

In the step of forming the first source electrode 173a and the first drain electrode 175a, a first field dispersion layer 177a may be formed together. The first field dispersion layer 177a may be positioned between the first source electrode 173a and the first drain electrode 175a. The first field dispersion layer 177a may overlap with the gate electrode 155. The first field dispersion layer 177a may be electrically connected to the first source electrode 173a. The first field dispersion layer 177a may be formed integrally with the first source electrode 173a. The first field dispersion layer 177a may include the same material as the first source electrode 173a and may be positioned in the same layer as the first source electrode 173a.

Accordingly, the lower protection layer 180 may be positioned on the barrier layer 136 between the first source electrode 173a and the first drain electrode 175a. The lower protection layer 180 may overlap the drift region DTR of the channel layer 132 in the vertical direction (e.g., the thickness direction of the channel layer 132).

Additionally, the lower protection layer 180 may be positioned between the barrier layer 136 and the first field dispersion layer 177a. At least a portion of the lower protection layer 180 may overlap with the first field dispersion layer 177a in the vertical direction (e.g., the thickness direction of the channel layer 132). Accordingly, the portion of the lower protection layer 180 that overlaps the field dispersion layer 177 in the vertical direction (for example, the thickness direction of the channel layer 132) may cover the gate semiconductor layer 152 and the gate electrode 155. Accordingly, the barrier layer 136, the gate semiconductor layer 152, and the gate electrode 155 may be protected by the lower protection layer 180.

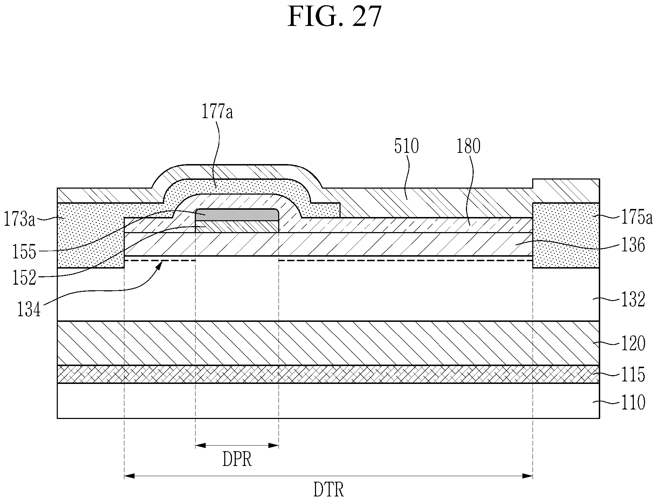

As shown in FIG. 27, a first interlayer insulating layer 510 may be formed on the first source electrode 173a, the first field dispersion layer 177a, the lower protection layer 180, and the first drain electrode 175a. The first interlayer insulating layer 510 may be positioned above the lower protection layer 180 and the first field dispersion layer 177a. The first interlayer insulating layer 510 may cover the lower protection layer 180 and the first field dispersion layer 177a.

In an embodiment, the first interlayer insulating layer 510 may include an insulating material. For example, the first interlayer insulating layer 510 may include silicon oxynitride (SiON), silicon carbon nitride (SiCN), silicon oxycarbonitride (SiOCN), silicon nitride (SiN), or a combination thereof. Also, the first interlayer insulating layer 510 may include a material such as aluminum oxide (Al₂O₃)

In an embodiment, the first interlayer insulating layer 510 may include a first element and a second element different from the first element. Here, the first element may be nitrogen (N), and the second element may be silicon (Si). For example, if the first interlayer insulating layer 510 includes silicon oxynitride (SiON), silicon carbon nitride (SiCN), silicon oxycarbonitride (SiOCN), silicon nitride (SiN), or a combination thereof, the first element may be nitrogen (N), and the second element may be silicon (Si).

At this time, the first interlayer insulating layer 510 may include the first element of a first content (at%). Here, the first element of the first content (at%) of the first interlayer insulating layer 510 may mean the content (at%) of the first element for the entire content of the first interlayer insulating layer 510. For example, if the first interlayer insulating layer 510 includes silicon oxynitride (SiON), the first content (at%) may mean the content (at%) of nitrogen(N) for the entire content of silicon (Si), nitrogen (N), and oxygen (O) of the first interlayer insulating layer 510. For example, the first content (at%) of the first element of the first interlayer insulating layer 510 may be greater than 0at% and less than about 60at%, preferably about 3at% to about 30at%.

In an embodiment, the first content (at%) of the first element of the first interlayer insulating layer 510 may be greater than the second content (at%) of the first element of the lower protection layer 180. For example, the first content (at%) of the first element of the first interlayer insulating layer 510 and the second content (at%) of the first element of the lower protection layer 180 may have constant values without a relationship to the distance from the bottom surface 180_B of the lower protection layer 180. The first content (N1 (at%) of FIG. 3) of the first element of the first interlayer insulating layer 510 may be larger than the second content (N2 (at%) of FIG. 3) of the first element of the lower protection layer 180. However, the embodiments are not limited thereto, the first content (at%) of the first element of the first interlayer insulating layer 510 and/or the second content (at%) of the first element of the lower protection layer 180 may have different values depending on the distance from the bottom surface of the lower protection layer 180.

As an example, when the first interlayer insulating layer 510 and the lower protection layer 180 include silicon oxynitride (SiON), the first content (at%) of nitrogen (N) in the first interlayer insulating layer 510 may be greater than the second content (at%) of nitrogen (N) in the lower protection layer 180. Therefore, the sum of the content (at%) of silicon (Si) and the content of oxygen (O) for the entire content (at%) of the first interlayer insulating layer 510 may be smaller than the sum of the content (at%) of silicon (Si) and the content of oxygen (O) for the entire content (at%) of the lower protection layer 180. As another example, if the first interlayer insulating layer 510 includes silicon oxynitride (SiON) and the lower protection layer 180 includes silicon oxide SiO2, the first content (at%) of nitrogen (N) in the first interlayer insulating layer 510 may be greater than the second content (at%) of nitrogen (N) in the lower protection layer 180. In this case, the lower protection layer 180 may not include the first element (e.g., nitrogen(N)). That is, the second content (at%) of the first element of the lower protection layer 180 may be 0.

As another example, when the first interlayer insulating layer 510 and the lower protection layer 180 include silicon nitride (SiN), the first content (at%) of nitrogen (N) in the first interlayer insulating layer 510 may be greater than the second content (at%) of nitrogen (N) in the lower protection layer 180. Therefore, the content (at%) of silicon (Si) for the entire content (at%) of the first interlayer insulating layer 510 may be less than the sum of the content (at%) of silicon (Si) for the entire content (at%) of the lower protection layer 180.

In an embodiment, the first interlayer insulating layer 510 was described as being composed of a single layer, but it is not limited thereto. For example, the first interlayer insulating layer 510 may be composed of multiple layers sequentially stacked on the lower protection layer 180.

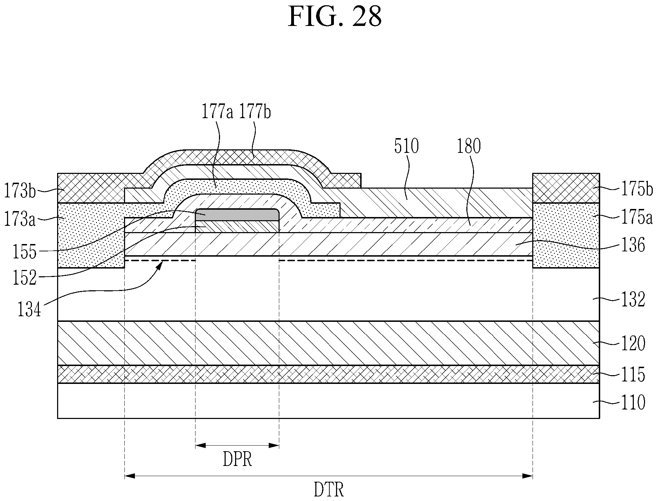

As shown in FIG. 28, at least a portion of the first interlayer insulating layer 510 may be removed, a conductive material may be deposited and then patterned to form a second source electrode 173b and a second drain electrode 175b.

First, a third trench and a fourth trench may be formed by etching at least a portion of the first interlayer insulating layer 510 positioned on the first source electrode 173a and the first drain electrode 175a. Accordingly, the portion of the first interlayer insulating layer 510 positioned on the first source electrode 173a and the first drain electrode 175a may be penetrated by the third trench and the fourth trench. The inner wall of the third trench and the fourth trench may be defined by the first interlayer insulating layer 510. The bottom surface of the third trench may be defined by the first source electrode 173a. The bottom surface of the fourth trench may be defined by the first drain electrode 175a. Accordingly, the upper surfaces of the first source electrode 173a and the first drain electrode 175a may be exposed.

Subsequently, a conductive material may be deposited in the third trench and the fourth trench and then patterned to form the second source electrode 173b and the second drain electrode 175b. Since the process of forming the second source electrode 173b and the second drain electrode 175b is substantially the same as the process of forming the first source electrode 173a and the first drain electrode 175a, detailed descriptions thereof will be omitted.

In the step of forming the second source electrode 173b and the second drain electrode 175b, a second field dispersion layer 177b may be formed together. The second field dispersion layer 177b may be positioned between the second source electrode 173b and the second drain electrode 175b. The second field dispersion layer 177b may overlap with the gate electrode 155. The second field dispersion layer 177b may be electrically connected to the second source electrode 173b. The second field dispersion layer 177b may be formed integrally with the second source electrode 173b. The second field dispersion layer 177b may include the same material as the second source electrode 173b and may be positioned in the same layer as the second source electrode 173b.

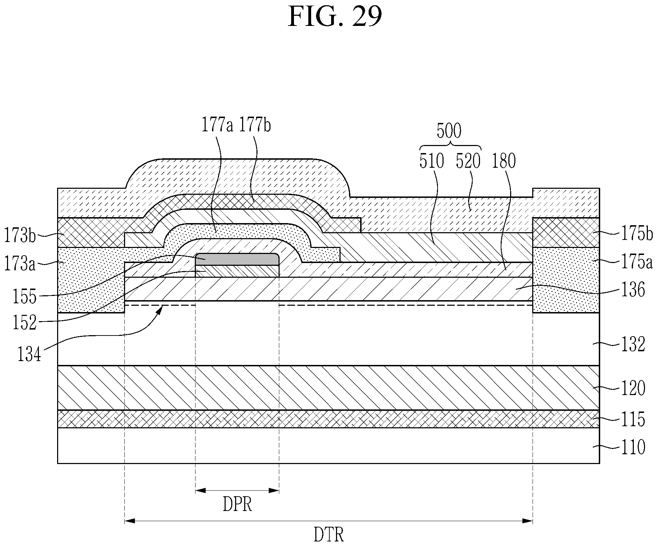

As shown in FIG. 29, a second interlayer insulating layer 520 may be formed on the second source electrode 173b, the second field dispersion layer 177b, the first interlayer insulating layer 510, and the second drain electrode 175b. The second interlayer insulating layer 520 may be positioned above the first interlayer insulating layer 510 and the second field dispersion layer 177b. The second interlayer insulating layer 520 may cover the first interlayer insulating layer 510 and the second field dispersion layer 177b.

In an embodiment, the second interlayer insulating layer 520 may include an insulating material. The second interlayer insulating layer 520 may include the same material as the first interlayer insulating layer 510, but it is not limited thereto. For example, the second interlayer insulating layer 520 may include silicon oxynitride (SiON), silicon carbon nitride (SiCN), silicon oxycarbonitride (SiOCN), silicon nitride (SiN), or a combination thereof. Also, the second interlayer insulating layer 520 may include a material such as aluminum oxide (Al₂O₃).

In an embodiment, the second interlayer insulating layer 520 may include a first element and a second element different from the first element. Here, the first element may be nitrogen (N), and the second element may be silicon (Si). As an example, if the second interlayer insulating layer 520 includes silicon oxynitride (SiON), silicon carbon nitride (SiCN), silicon oxycarbonitride (SiOCN), silicon nitride (SiN), or a combination thereof, the first element may be nitrogen (N), and the second element may be silicon (Si).

At this time, the second interlayer insulating layer 520 may include the first element of a third content (at%). Here, the third content (at%) of the first element of the second interlayer insulating layer 520 may mean the content (at%) of the first element for the entire content of the second interlayer insulating layer 520. For example, when the second interlayer insulating layer 520 includes silicon oxynitride (SiON), it may mean the content (at%) of nitrogen (N) for the entire content of silicon (Si), nitrogen (N), and oxygen (O) of the second interlayer insulating layer 520 .

Referring further to FIG. 3, in an embodiment, the third content (at%) of the first element of the second interlayer insulating layer 520 may be greater than the second content (at%) of the first element of the lower protection layer 180. Additionally, the third content (at%) of the first element of the second interlayer insulating layer 520 may be smaller than the first content (at%) of the first element of the first interlayer insulating layer 510.

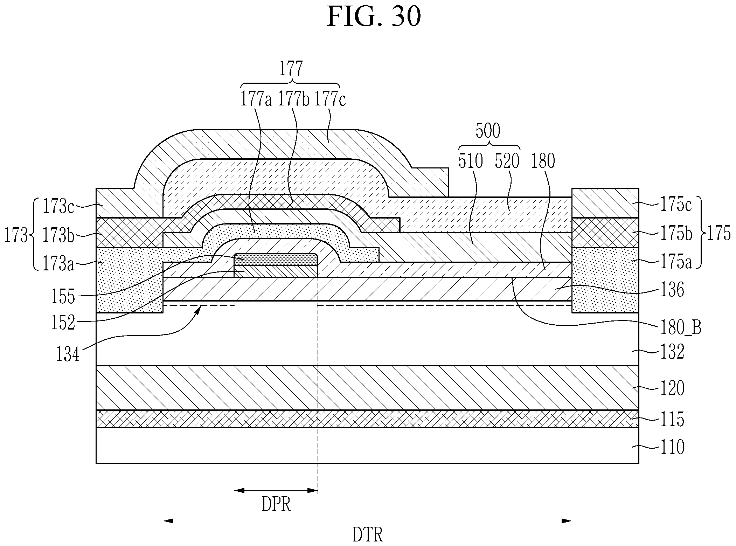

As shown in FIG. 30, at least a portion of the second interlayer insulating layer 520 may be removed, a conductive material may be deposited and then patterned to form a third source electrode 173c and a third drain electrode 175c.

For example, first, a fifth trench and a sixth trench may be formed by etching at least a portion of the second interlayer insulating layer 520 positioned on the second source electrode 173b and the second drain electrode 175b. Accordingly, the portion of the second interlayer insulating layer 520 positioned over the second source electrode 173b and the second drain electrode 175b may be penetrated by the fifth trench and the sixth trench. The inner wall of the fifth trench and the sixth trench may be defined by the second interlayer insulating layer 520. The bottom surface of the fifth trench may be defined by the second source electrode 173b. The bottom surface of the sixth trench may be defined by the second drain electrode 175b. Accordingly, the upper surfaces of the second source electrode 173b and the second drain electrode 175b may be exposed.

Subsequently, a conductive material may be deposited in the fifth trench and the sixth trench and then patterned to form a third source electrode 173c and a third drain electrode 175c. Since the process of forming the third source electrode 173c and the third drain electrode 175c is substantially the same as the process of forming the second source electrode 173b and the second drain electrode 175b, a detailed description thereof will be omitted.

In the step of forming the third source electrode 173c and the third drain electrode 175c, a third field dispersion layer 177c may be formed together. The third field dispersion layer 177c may be positioned between the third source electrode 173c and the third drain electrode 175c. The third field dispersion layer 177c may overlap with the gate electrode 155. The third field dispersion layer 177c may be electrically connected to the third source electrode 173c. The third field dispersion layer 177c may be formed integrally with the third source electrode 173c. The third field dispersion layer 177c may include the same material as the third source electrode 173c and may be positioned in the same layer as the third source electrode 173c.

Accordingly, the semiconductor device according to various embodiments may be formed.

While this disclosure has been described in connection with what is presently considered to be practical examples, it is to be understood that the disclosure is not limited to the disclosed embodiments, but, on the contrary, is intended to cover various modifications and equivalent arrangements included within the scope of the appended claims.

### <Description of symbols>

- 110:: substrate
- 132:: channel layer
- 134:: two-dimensional electron gas
- 136:: barrier layer
- 152:: gate semiconductor layer
- 155:: gate electrode
- 173:: source electrode
- 175:: drain electrode
- 180:: lower protection layer
- 500:: interlayer insulating layer
- 510:: first interlayer insulating layer
- 520:: second interlayer insulating layer

Embodiments are set out in the following numbered clauses:
1. A semiconductor device comprising:
   a channel layer,
   a barrier layer positioned above the channel layer and including a material having a different energy band gap from an energy band gap of the channel layer,
   a gate electrode positioned above the barrier layer,
   a gate semiconductor layer positioned between the barrier layer and the gate electrode,
   a first source electrode positioned on a first side of the gate electrode, and a first drain electrode positioned on a second, opposite side of the gate electrode, the first source electrode and the first drain electrode each connected to the channel layer,
   a lower protection layer covering the barrier layer and the gate electrode,
   a first field dispersion plate connected to the first source electrode and positioned above the lower protection layer, and
   a first interlayer insulating layer positioned above the first field dispersion plate and the lower protection layer and including a first element of a first content (at%) in relation to the entire first interlayer insulating layer,
   wherein the lower protection layer includes the first element of which a second content (at%) in relation to the entire lower protection layer is less than the first content (at%).
2. The semiconductor device of clause 1, wherein:
   the first content (at%) is not constant throughout a thickness of the entire first interlayer insulating layer, and increases as a distance away from the bottom surface of the lower protection layer increases.
3. The semiconductor device of clause 1 or clause 2, wherein:
   the second content (at%) is not constant throughout a thickness of the entire lower protection layer, and increases, at least for a portion of the lower protection layer, as a distance away from the bottom surface of the lower protection layer increases.
4. The semiconductor device of clause 3, wherein:
   a maximum value of the second content (at%) in any vertical-level slice of the lower protection layer is less than a minimum value of the first content (at%) in any vertical-level slice of the first interlayer insulating layer.
5. The semiconductor device of any preceding clause, wherein:
   the first element is nitrogen.
6. The semiconductor device of clause 5, wherein:
   the first interlayer insulating layer and the lower protection layer each include silicon oxynitride, silicon carbon nitride, silicon oxycarbonitride, silicon nitride, or a combination thereof.
7. The semiconductor device of clause 5, wherein:
   the first interlayer insulating layer includes silicon oxynitride, silicon carbon nitride, silicon oxycarbonitride, silicon nitride, or a combination thereof, and
   the lower protection layer includes silicon oxide, silicon carbon oxide, or a combination thereof.
8. The semiconductor device of any preceding clause, wherein:
   the second content (at%) of the first element of the lower protection layer is greater than 0 at% and less than 1 at%.
9. The semiconductor device of clause 8, wherein:
   the first content (at%) of the first element of the first interlayer insulating layer is equal to or greater than 3 at% and less than 30 at%.
10. The semiconductor device of any preceding clause, further comprising:
   a second source electrode positioned above the first source electrode,
   a second drain electrode positioned above the first drain electrode,
   a second field dispersion plate connected to the second source electrode and positioned above the first interlayer insulating layer, and
   a second interlayer insulating layer positioned above the second field dispersion plate and the first interlayer insulating layer and including the first element of a third content (at%) in relation to the entire second interlayer insulating layer different from the first content (at%) and the second content (at%).
11. The semiconductor device of clause 10, wherein:
   the third content (at%) of the second interlayer insulating layer is greater than or equal to the second content (at%) of the lower protection layer.
12. The semiconductor device of clause 10 or clause 11, wherein:
   the third content (at%) of the second interlayer insulating layer is smaller than the first content (at%) of the first interlayer insulating layer.
13. The semiconductor device of any of clauses 10 to 12, wherein:
   the second field dispersion plate is formed at the same layer as the second source electrode, includes the same material as the second source electrode, and is integrated with the second source electrode.
14. The semiconductor device of any preceding clause, wherein:
   the lower protection layer includes:
   a first lower protection layer positioned on the barrier layer and including the first element of a third content (at%) in relation to the entire first lower protection layer, and
   a second lower protection layer positioned between the first lower protection layer and the first field dispersion plate and including the first element of a fourth content (at%) in relation to the entire second lower protection layer, the fourth content (at%) different from the third content (at%), and
   the third content (at%) and the fourth content (at%) are smaller than the first content (at%) of the first element of the first interlayer insulating layer.
15. The semiconductor device of clause 14, wherein:
   the first interlayer insulating layer includes:
   a first sub-interlayer insulating layer positioned above the first field dispersion plate and including the first element of a fifth content (at%) in relation to the entire first sub-interlayer insulating layer, and
   a second sub-interlayer insulating layer positioned between the lower protection layer and the first field dispersion plate including the first element of a sixth content (at%) in relation to the entire second sub-interlayer insulating layer, the sixth content (at%) different from the fifth content (at%), and
   the fifth content (at%) and the sixth content (at%) are greater than the second content (at%) of the first element of the lower protection layer.
16. A semiconductor device comprising:
   a channel layer,
   a barrier layer positioned above the channel layer and including a material having a different energy band gap from an energy band gap of the channel layer,
   a gate electrode positioned above the barrier layer,
   a gate semiconductor layer positioned between the barrier layer and the gate electrode,
   a first source electrode positioned on a first side of the gate electrode, and a first drain electrode positioned on a second, opposite side of the gate electrode, the first source electrode and the first drain electrode each connected to the channel layer,
   a lower protection layer covering the barrier layer and the gate electrode,
   a field dispersion plate connected to the source electrode and positioned above the lower protection layer, and
   an interlayer insulating layer positioned above the field dispersion plate and the lower protection layer and including nitrogen,
   wherein the lower protection layer includes a content (at%) of nitrogen in relation to the entire lower protection layer less than the content (at%) of nitrogen of the interlayer insulating layer in relation to the entire interlayer insulating layer.
17. The semiconductor device of clause 16, wherein:
   the field dispersion plate includes:
   a first field dispersion plate connected to the source electrode and positioned above the lower protection layer, and
   a second field dispersion plate positioned on the first field dispersion plate,
   the interlayer insulating layer includes:
      a first interlayer insulating layer positioned between the first field dispersion plate and the second field dispersion plate and including a first content (at%) of nitrogen in relation to the entire first interlayer insulating layer, and
      a second interlayer insulating layer positioned on the second field dispersion plate and the first interlayer insulating layer, and
      the lower protection layer includes nitrogen in a second content (at%) in relation to the entire lower protection layer less than the first content (at%).
18. The semiconductor device of clause 17, wherein:
   the second interlayer insulating layer includes nitrogen of a third content (at%) in relation to the entire second interlayer insulating layer, the third content (at%) greater than or equal to the second content (at%).
19. A semiconductor device comprising:
   a substrate,
   a channel layer including GaN on the substrate,
   a barrier layer positioned above the channel layer and including AlGaN,
   a gate electrode positioned above the barrier layer and including a metal material,
   a gate semiconductor layer positioned between the barrier layer and the gate electrode and including GaN doped with a P-type impurity,
   a first source electrode positioned on a first side of the gate electrode, and a first drain electrode positioned on a second, opposite side of the gate electrode, the first source electrode and the first drain electrode each connected to the channel layer,
   a lower protection layer covering the barrier layer and the gate electrode,
   a first field dispersion plate connected to the first source electrode, integrated with the first source electrode, and positioned above the lower protection layer, and
   a first interlayer insulating layer positioned above the first field dispersion plate and the lower protection layer and including a first element and a second element different from the first element,
   wherein the lower protection layer includes the second element, or the second element and the first element, and the content (at%) of the first element of the lower protection layer in relation to the entire lower protection layer is smaller than the content (at%) of the first element of the interlayer insulating layer in relation to the entire first interlayer insulating layer.
20. The semiconductor device of clause 19, wherein:
   the first element is nitrogen, and the second element is silicon.

## Claims

1. A semiconductor device comprising:
a channel layer,
a barrier layer positioned above the channel layer and including a material having a different energy band gap from an energy band gap of the channel layer,
a gate electrode positioned above the barrier layer,
a gate semiconductor layer positioned between the barrier layer and the gate electrode,
a first source electrode positioned on a first side of the gate electrode, and a first drain electrode positioned on a second, opposite side of the gate electrode, the first source electrode and the first drain electrode each connected to the channel layer,
a lower protection layer covering the barrier layer and the gate electrode,
a first field dispersion plate connected to the first source electrode and positioned above the lower protection layer, and
a first interlayer insulating layer positioned above the first field dispersion plate and the lower protection layer and including a first element of a first content (at%) in relation to the entire first interlayer insulating layer,
wherein the lower protection layer includes the first element of which a second content (at%) in relation to the entire lower protection layer is less than the first content (at%).

2. The semiconductor device of claim 1, wherein:
the first content (at%) is not constant throughout a thickness of the entire first interlayer insulating layer, and increases as a distance away from the bottom surface of the lower protection layer increases.

3. The semiconductor device of claim 1 or claim 2, wherein:
the second content (at%) is not constant throughout a thickness of the entire lower protection layer, and increases, at least for a portion of the lower protection layer, as a distance away from the bottom surface of the lower protection layer increases.

4. The semiconductor device of claim 3, wherein:
a maximum value of the second content (at%) in any vertical-level slice of the lower protection layer is less than a minimum value of the first content (at%) in any vertical-level slice of the first interlayer insulating layer.

5. The semiconductor device of any preceding claim, wherein:
the first element is nitrogen.

6. The semiconductor device of claim 5, wherein:
the first interlayer insulating layer and the lower protection layer each include silicon oxynitride, silicon carbon nitride, silicon oxycarbonitride, silicon nitride, or a combination thereof.

7. The semiconductor device of claim 5, wherein:
the first interlayer insulating layer includes silicon oxynitride, silicon carbon nitride, silicon oxycarbonitride, silicon nitride, or a combination thereof, and
the lower protection layer includes silicon oxide, silicon carbon oxide, or a combination thereof.

8. The semiconductor device of any preceding claim, wherein:
the second content (at%) of the first element of the lower protection layer is greater than 0 at% and less than 1 at%.

9. The semiconductor device of claim 8, wherein:
the first content (at%) of the first element of the first interlayer insulating layer is equal to or greater than 3 at% and less than 30 at%.

10. The semiconductor device of any preceding claim, further comprising:
a second source electrode positioned above the first source electrode,
a second drain electrode positioned above the first drain electrode,
a second field dispersion plate connected to the second source electrode and positioned above the first interlayer insulating layer, and
a second interlayer insulating layer positioned above the second field dispersion plate and the first interlayer insulating layer and including the first element of a third content (at%) in relation to the entire second interlayer insulating layer different from the first content (at%) and the second content (at%).

11. The semiconductor device of claim 10, wherein:
the third content (at%) of the second interlayer insulating layer is greater than or equal to the second content (at%) of the lower protection layer.

12. The semiconductor device of claim 10 or claim 11, wherein:
the third content (at%) of the second interlayer insulating layer is smaller than the first content (at%) of the first interlayer insulating layer.

13. The semiconductor device of any of claims 10 to 12, wherein:
the second field dispersion plate is formed at the same layer as the second source electrode, includes the same material as the second source electrode, and is integrated with the second source electrode.

14. The semiconductor device of any preceding claim, wherein:
the lower protection layer includes:
a first lower protection layer positioned on the barrier layer and including the first element of a third content (at%) in relation to the entire first lower protection layer, and
a second lower protection layer positioned between the first lower protection layer and the first field dispersion plate and including the first element of a fourth content (at%) in relation to the entire second lower protection layer, the fourth content (at%) different from the third content (at%), and
the third content (at%) and the fourth content (at%) are smaller than the first content (at%) of the first element of the first interlayer insulating layer.

15. The semiconductor device of claim 14, wherein:
the first interlayer insulating layer includes:
a first sub-interlayer insulating layer positioned above the first field dispersion plate and including the first element of a fifth content (at%) in relation to the entire first sub-interlayer insulating layer, and
a second sub-interlayer insulating layer positioned between the lower protection layer and the first field dispersion plate including the first element of a sixth content (at%) in relation to the entire second sub-interlayer insulating layer, the sixth content (at%) different from the fifth content (at%), and
the fifth content (at%) and the sixth content (at%) are greater than the second content (at%) of the first element of the lower protection layer.
